(19) Europäisches Patentamt
European Patent Office
Office européen des brevets

(11) **EP 2 876 468 A1**

(12) **EUROPEAN PATENT APPLICATION**
published in accordance with Art. 153(4) EPC

(43) Date of publication:
27.05.2015 Bulletin 2015/22

(21) Application number: 13819889.0

(22) Date of filing: 02.07.2013

(51) Int Cl.:
$G02B\ 1/11^{(2015.01)}$     $B32B\ 7/02^{(2006.01)}$
$G06F\ 3/041^{(2006.01)}$     $G09F\ 9/00^{(2006.01)}$

(86) International application number:
PCT/JP2013/068142

(87) International publication number:
WO 2014/013862 (23.01.2014 Gazette 2014/04)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 20.07.2012 JP 2012162093

(71) Applicant: Dexerials Corporation
Tokyo 141-0032 (JP)

(72) Inventors:
• ENDOH Sohmei
Shinagawa-ku, Tokyo 141-0032 (JP)
• WADA Yutaka
Shinagawa-ku, Tokyo 141-0032 (JP)
• FUKUDA Tomoo
Shinagawa-ku, Tokyo 141-0032 (JP)

(74) Representative: Witte, Weller & Partner
Patentanwälte mbB
Postfach 10 54 62
70047 Stuttgart (DE)

(54) **CONDUCTIVE OPTICAL ELEMENT, INPUT ELEMENT AND DISPLAY ELEMENT**

(57) A conductive optical device includes: a base; a plurality of structures supported by the base, and arranged at a pitch that is equal to or shorter than a wavelength of visible light; and a transparent conductive layer provided on a surface-side of the structures, and having a shape that follows along a surface shape of the structures. The following relational expressions are satisfied:

$$y \geq -1.785x + 3.238$$

$$y \leq 0.686$$

where x is a refractive index and y is an aspect ratio, of each of the structures.

[ FIG. 1A ]

(Cont. next page)

EP 2 876 468 A1

[ FIG. 1B ]

[ FIG. 1C ]

**Description**

TECHNICAL FIELD

The technology relates to a conductive optical device, to an input device, and to a display device. More specifically, the technology relates to a conductive optical device having an antireflection function.

BACKGROUND ART

A conductive optical device, in which a transparent conductive layer is formed on a planar surface of a base, is used for a display unit such as an electronic paper as well as for an input unit such as a touch panel. As a material of the transparent conductive layer used in the conductive optical device, a high refractive index material (such as ITO (Indium Tin Oxide)) is used. This may result in high reflectance depending on a thickness of the transparent conductive layer and impairment of quality of the display unit and the input unit accordingly.

In order to improve transmission characteristics of the conductive optical device, a technology of forming an optical multilayer film is used. For example, Patent Document 1 proposes a conductive optical device directed to a touch panel, in which the optical multilayer film is provided between a base material and a transparent conductive layer, and the optical multilayer film is formed by sequentially laminating a plurality of dielectric films having different refractive indices from one another. However, the proposed technology is insufficient in optical characteristics. The optical characteristics as used herein refer to reflection characteristics and/or the transmission characteristics in the presence or absence of an ITO film.

PRIOR ART DOCUMENT

PATENT DOCUMENT

Patent Document 1: Japanese Unexamined Patent Application Publication No. 2003-136625

SUMMARY OF THE INVENTION

Accordingly, it is desirable to provide a conductive optical device, an input device, and a display device that have superior optical characteristics.

A conductive optical device according to an embodiment of the technology includes:

a base;
a plurality of structures supported by the base, and arranged at a pitch that is equal to or shorter than a wavelength of visible light; and
a transparent conductive layer provided on a surface-side of the structures, and having a shape that follows along a surface shape of the structures,
wherein the following relational expressions (1) and (2) are satisfied:

$$y \geq -1.785x + 3.238 \qquad (1)$$

$$y \leq 0.686 \qquad (2)$$

where x is a refractive index and y is an aspect ratio, of each of the structures.

The conductive optical device according to an embodiment of the technology may be suitably applied to a device such as an input device and a display device.

In an embodiment of the technology, a shape of a bottom surface of each of the structures may be preferably an ellipse or a circle. In the technology, shapes such as an ellipse, a circle (a true circle), a sphere, and an ellipsoid encompass not only a complete ellipse, a complete circle, a complete sphere, and a complete ellipsoid that are mathematically defined but also shapes such as an ellipse, a circle, a sphere, and an ellipsoid that have some amounts of distortion.

In an embodiment of the technology, each of the structures may preferably have a convex shape or a concave shape and may be preferably arranged in a predetermined lattice pattern. The lattice pattern may be preferably a tetragonal lattice pattern, a quasi-tetragonal lattice pattern, a hexagonal lattice pattern, or a quasi-hexagonal lattice pattern.

In an embodiment of the technology, an arrangement pitch P1 of the structures in the same track may be preferably longer than an arrangement pitch P2 of the structures between two adjacent tracks. This improves a filling rate of the structures each having an elliptical cone shape or a truncated elliptical cone shape, and therefore further improves optical characteristics.

In an embodiment of the technology, in a case where the respective structures form a hexagonal lattice pattern or a quasi-hexagonal lattice pattern on the surface of the base, a ratio P1/P2 may preferably satisfy a relationship of $1.00 \leq P1/P2 \leq 1.1$ or $1.00 < P1/P2 \leq 1.1$ where P1 is the arrangement pitch of the structures in the same track and P2 is the arrangement pitch of the structures between two adjacent tracks. By setting such a numerical range, it is possible to improve the filling rate of the structures each having an elliptical cone shape or a truncated elliptical cone shape, and therefore to further improve the optical characteristics.

In an embodiment of the technology, in a case where the respective structures form a hexagonal lattice pattern or a quasi-hexagonal lattice pattern on the surface of the base, each of the structures may preferably have a major-axis direction oriented in a direction in which the tracks extend, and may preferably have an elliptical cone shape or a truncated elliptical cone shape that has an inclination that is sharper at a center portion thereof than at a tip portion and a bottom portion thereof. By providing such a shape, it is possible to further improve the optical characteristics.

In an embodiment of the technology, in a case where the respective structures form a hexagonal lattice pattern or a quasi-hexagonal lattice pattern on the surface of the base, a height or a depth of each of the structures in the extending direction of the track may be preferably smaller than a height or a depth of each of the structures in a line direction of the track. In a case where such a relationship is not satisfied, it is necessary to increase the arrangement pitch in the extending direction of the track, and the filling rate of the structures in the extending direction of the track is therefore decreased. Such decrease in filling rate tends to result in degradation in the optical characteristics.

In an embodiment of the technology, in a case where the respective structures form a tetragonal lattice pattern or a quasi-tetragonal lattice pattern on the surface of the base, the arrangement pitch P1 of the structures in the same track may be preferably longer than the arrangement pitch P2 of the structures between two adjacent tracks. This improves the filling rate of the structures each having an elliptical cone shape or a truncated elliptical cone shape, and therefore further improves the optical characteristics.

In a case where the respective structures form a tetragonal lattice pattern or a quasi-tetragonal lattice pattern on the surface of the base, the ratio P1/P2 may preferably satisfy a relationship of $1.4 < P1/P2 \leq 1.5$ where P1 is the arrangement pitch of the structures in the same track and P2 is the arrangement pitch of the structures between two adjacent tracks. By setting such a numerical range, it is possible to improve the filling rate of the structures each having an elliptical cone shape or a truncated elliptical cone shape, and therefore to further improve the optical characteristics.

In a case where the respective structures form a tetragonal lattice pattern or a quasi-tetragonal lattice pattern on the surface of the base, each of the structures may preferably have a major-axis direction oriented in the direction in which the tracks extend, and may preferably have an elliptical cone shape or a truncated elliptical cone shape that has an inclination that is sharper at the center portion thereof than at the tip portion and the bottom portion thereof. By providing such a shape, it is possible to further improve the optical characteristics.

In a case where the respective structures form a tetragonal lattice pattern or a quasi-tetragonal lattice pattern on the surface of the base, a height or a depth of each of the structures in a direction of 45° or about 45° with respect to the track may be preferably smaller than the height or the depth of each of the structures in the line direction of the track. In a case where such a relationship is not satisfied, it is necessary to increase the arrangement pitch in the direction of 45° or about 45° with respect to the track, and the filling rate of the structures in the direction of 45° or about 45° with respect to the track is therefore decreased. Such decrease in filling rate tends to result in degradation in the optical characteristics.

In an embodiment of the technology, a number of structures provided on the surface of the base at a fine pitch may preferably form a plurality of lines of tracks and may preferably form a pattern selected from a group consisting of a hexagonal lattice pattern, a quasi-hexagonal lattice pattern, a tetragonal lattice pattern, and a quasi-tetragonal lattice pattern across three adjacent tracks. This increases filling density of the structures on the surface. Accordingly, it is possible to achieve a conductive optical device having superior optical characteristics.

In an embodiment of the technology, the conductive optical device may be preferably fabricated by a method in which a process of fabricating a master of an optical disk and an etching process are used in combination. This makes it possible to manufacture a master for fabricating the conductive optical device efficiently in a short time and to allow a base to have a larger size. Accordingly, it is possible to improve productivity of the conductive optical device.

In an embodiment of the technology, the transparent conductive layer having a predetermined pattern may be formed on the optical layer provided with a corrugated surface having an average wavelength that is equal to or shorter than a wavelength of visible light so that the transparent conductive layer follows along the corrugated surface. Also, the refractive index x and the aspect ratio y of the structures satisfy predetermined relational expressions. Accordingly, it is possible to achieve superior optical characteristics.

As described above, according to an embodiment of the technology, it is possible to achieve a conductive optical device having superior optical characteristics.

BRIEF DESCRIPTION OF THE DRAWINGS

[FIG. 1A] FIG. 1A is a cross-sectional view illustrating an example of a configuration of a conductive optical device according to a first embodiment of the technology.
[FIG. 1B] FIG. 1B is an enlarged cross-sectional view illustrating a first region $R_1$ illustrated in FIG. 1A in an enlarged manner.
[FIG. 1C] FIG. 1C is an enlarged cross-sectional view illustrating a second region $R_2$ illustrated in FIG. 1A in an enlarged manner.
[FIG. 2A] FIG. 2A is a plan view illustrating an example of a surface of an optical layer formed with a plurality of structures, and also illustrating a part of the optical layer surface in an enlarged manner.
[FIG. 2B] FIG. 2B is a perspective view illustrating a part of the optical layer surface illustrated in FIG. 2A in an enlarged manner.
[FIG. 3] FIG. 3 is a schematic view for describing a method of setting bottom surfaces of respective structures when a boundary between the structures is vague.
[FIG. 4A] FIG. 4A is a schematic view illustrating a height of the structure in an extending direction of a track.
[FIG. 4B] FIG. 4B is a schematic view illustrating a height of the structure in a line direction of the track.
[FIG. 5] FIG. 5 is a schematic view illustrating a modification of the configuration of the conductive optical device according to the first embodiment of the technology.
[FIG. 6] FIG. 6 is a schematic view illustrating another modification of the configuration of the conductive optical device according to the first embodiment of the technology.
[FIG. 7] FIG. 7 is a schematic view for describing optical characteristics of the conductive optical device according to the first embodiment of the technology.
[FIG. 8A] FIG. 8A is a perspective view illustrating an example of a configuration of a roll-shaped master.
[FIG. 8B] FIG. 8B is a plan view illustrating a part of the roll-shaped master illustrated in FIG. 8A in an enlarged manner.
[FIG. 8C] FIG. 8C is a cross-sectional view taken along a track T illustrated in FIG. 8B.
[FIG. 9] FIG. 9 is a schematic view illustrating an example of a configuration of a roll-shaped master exposure apparatus.
[FIG. 10A] FIG. 10A is a process drawing for describing an example of a method of manufacturing the conductive optical device according to the first embodiment of the technology.
[FIG. 10B] FIG. 10B is a process drawing for describing a process subsequent to that illustrated in FIG. 10A.
[FIG. 10C] FIG. 10C is a process drawing for describing a process subsequent to that illustrated in FIG. 10B.
[FIG. 10D] FIG. 10D is a process drawing for describing a process subsequent to that illustrated in FIG. 10C.
[FIG. 11A] FIG. 11A is a process drawing for describing an example of the method of manufacturing the conductive optical device according to the first embodiment of the technology.
[FIG. 11B] FIG. 11B is a process drawing for describing a process subsequent to that illustrated in FIG. 11A.
[FIG. 11C] FIG. 11C is a process drawing for describing a process subsequent to that illustrated in FIG. 11B.
[FIG. 11D] FIG. 11D is a process drawing for describing a process subsequent to that illustrated in FIG. 11C.
[FIG. 12A] FIG. 12A is a plan view illustrating an example of the optical layer surface of the conductive optical device according to a second embodiment of the technology.
[FIG. 12B] FIG. 12B is a plan view illustrating a part of the optical layer surface illustrated in FIG. 12A in an enlarged manner.
[FIG. 13A] FIG. 13A is a cross-sectional view illustrating an example of the configuration of the conductive optical device according to a third embodiment of the technology.
[FIG. 13B] FIG. 13B is an enlarged cross-sectional view illustrating the first region $R_1$ illustrated in FIG. 13A in an enlarged manner.
[FIG. 13C] FIG. 13C is an enlarged cross-sectional view illustrating the second region $R_2$ illustrated in FIG. 13A in an enlarged manner.
[FIG. 14A] FIG. 14A is a cross-sectional view for describing an example of a configuration of an information input unit according to a fourth embodiment of the technology.
[FIG. 14B] FIG. 14B is an enlarged cross-sectional view illustrating a region $A_1$ and a region $A_2$ illustrated in FIG. 14A in an enlarged manner.

[FIG. 15A] FIG. 15A is an enlarged cross-sectional view illustrating the region $A_1$ illustrated in FIG. 14A in a further enlarged manner.

[FIG. 15B] FIG. 15B is an enlarged cross-sectional view illustrating the region $A_2$ illustrated in FIG. 14A in a further enlarged manner.

[FIG. 16A] FIG. 16A is an exploded perspective view for describing an example of the configuration of the information input unit according to the fourth embodiment of the technology.

[FIG. 16B] FIG. 16B is an exploded perspective view for describing an example of a configuration of a first conductive optical device provided in the information input unit according to the fourth embodiment of the technology.

[FIG. 17A] FIG. 17A is a cross-sectional view for describing an example of the configuration of the information input unit according to a fifth embodiment of the technology.

[FIG. 17B] FIG. 17B is a cross-sectional view illustrating, in an enlarged manner, a region in which corrugated surfaces formed with respective transparent conductive layers are opposed to each other.

[FIG. 17C] FIG. 17C is a cross-sectional view illustrating, in an enlarged manner, a region in which the corrugated surfaces, formed with no transparent conductive layer and thus exposed, are opposed to each other.

[FIG. 18A] FIG. 18A is an exploded perspective view for describing an example of the configuration of the information input unit according to the fifth embodiment of the technology.

[FIG. 18B] FIG. 18B is an exploded perspective view for describing an example of the configuration of the conductive optical device provided in the information input unit according to the fifth embodiment of the technology.

[FIG. 19A] FIG. 19A is a perspective view for describing an example of a configuration of an information display unit according to a sixth embodiment of the technology.

[FIG. 19B] FIG. 19B is a cross-sectional view illustrating, in an enlarged manner, a region in which the corrugated surfaces formed with the respective transparent conductive layers are opposed to each other.

[FIG. 19C] FIG. 19C is a cross-sectional view illustrating, in an enlarged manner, a region in which the corrugated surfaces, formed with no transparent conductive layer and thus exposed, are opposed to each other.

[FIG. 20A] FIG. 20A is a cross-sectional view for describing an example of a configuration of the information display unit according to a seventh embodiment of the technology.

[FIG. 20B] FIG. 20B is a cross-sectional view illustrating, in an enlarged manner, a region in which the corrugated surfaces formed with the respective transparent conductive layers are opposed to each other.

[FIG. 20C] FIG. 20C is a cross-sectional view illustrating, in an enlarged manner, a region in which the corrugated surfaces, formed with no transparent conductive layer and thus exposed, are opposed to each other.

[FIG. 21A] FIG. 21A is a diagram showing a reflection spectrum of a conductive optical sheet according to Example 1.

[FIG. 21B] FIG. 21B is a diagram showing a reflection spectrum of a conductive optical sheet according to Comparative example 1.

[FIG. 22] FIG. 22 is a graph showing a relationship of a refractive index of a conductive optical sheet according to each of Examples 2 to 11 and Comparative example 2 versus an aspect ratio thereof.

DESCRIPTION OF EMBODIMENTS

Some embodiments of the technology are described in the following order with reference to the accompanying drawings.

1. First Embodiment (an example of a conductive optical device in which structures are arrayed in a hexagonal lattice pattern)

2. Second Embodiment (an example of the conductive optical device in which the structures are arrayed in a tetragonal lattice pattern)

3. Third Embodiment (an example of the conductive optical device in which the structures are provided on both surfaces)

4. Fourth Embodiment (a first application example of applying the conductive optical device to an information input unit)

5. Fifth Embodiment (a second application example of applying the conductive optical device to the information input unit)

6. Sixth Embodiment (a first application example of applying the conductive optical device to an information display unit)

7. Seventh Embodiment (a second application example of applying the conductive optical device to the information display unit)

<1. First Embodiment>

[Configuration of Conductive Optical Device]

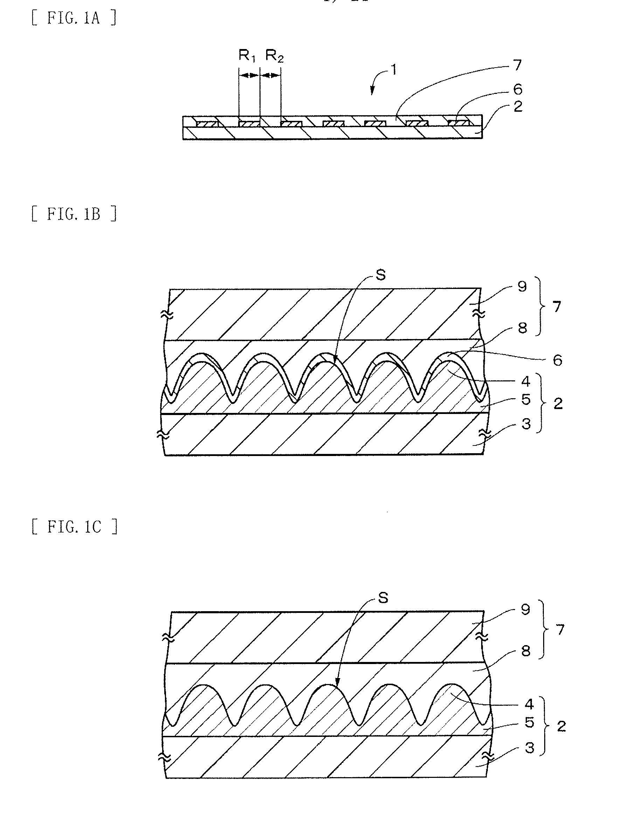

FIG. 1A is a cross-sectional view illustrating an example of a configuration of a conductive optical device according to a first embodiment of the technology. FIG. 1B is an enlarged cross-sectional view illustrating a first region $R_1$ illustrated in FIG. 1A in an enlarged manner. FIG. 1C is an enlarged cross-sectional view illustrating a second region $R_2$ illustrated in FIG. 1A in an enlarged manner. Such a conductive optical device 1 may include an optical layer (first optical layer) 2 and a transparent conductive layer 6. The optical layer 2 has a corrugated surface S on a surface (one principal surface) thereof. The transparent conductive layer 6 is so formed on the corrugated surface S as to follow along the corrugated surface S. The corrugated surface S on the surface side of the optical layer 2 is provided alternately with a first region $R_1$ and a second region $R_2$, and the transparent conductive layer 6 thus has a predetermined pattern. The first region $R_1$ is formed with the transparent conductive layer 6, and the second region $R_2$ is formed with no transparent conductive layer 6. Also, a configuration may be employed on an as-necessary basis that further includes an optical layer (second optical layer) 7 formed on the transparent conductive layer 6 as illustrated in FIGs. 1A to 1C. The conductive optical device 1 may preferably have flexibility.

(Optical Layer)

The optical layer 2 may include, for example, a base 3, and a plurality of structures 4 formed on a surface of the base 3 and supported by the base 3. The surface of the base 3 is formed with the structures 4, whereby the corrugated surface S is formed. The structures 4 and the base 3 may be formed separately or integrally, for example. In a case where the structures 4 and the base 3 are formed separately, a basal layer 5 may be further provided on an as-necessary basis between the structures 4 and the base 3. The basal layer 5 is a layer formed integrally with the structures 4 on the bottom surface side of the structures 4, and may be formed by curing an energy-ray-curable resin composite which may be similar to an energy-ray-curable resin composite of the structures 4.

The optical layer 7 may include, for example, a base 9, and an attaching layer 8 provided between the base 9 and the transparent conductive layer 6. The base 9 may be attached onto the transparent conductive layer 6 with the attaching layer 8 in between. The optical layer 7, however, is not limited to this example, and can be a coat (overcoat) of ceramic such as $SiO_2$.

(Base)

The bases 3 and 9 each may be a transparent base having transparency, for example. Examples of a material of each of the bases 3 and 9 may include a material containing a plastic material having transparency and a material containing glass or the like as a main component; however, the material thereof is not particularly limited to these materials.

Usable examples of the glass may include soda lime glass, lead glass, hard glass, vitreous silica, and liquid crystal glass (see "Chemistry Handbook" Introduction, P. I-537, The Chemical Society of Japan). Preferable examples of the plastic material may include, in view of optical characteristics such as transparency, a refractive index, and dispersion as well as various characteristics such as impact resistance, heat resistance, and durability: a (metha)acrylic-based resin such as polymethylmethacrylate, a copolymer of methyl methacrylate and a vinyl monomer such as any other alkyl(metha)acrylate or styrene; a polycarbonate-based resin such as polycarbonate or diethylene glycol-bis-allyl carbonate (CR-39); a heat-curable (metha)acrylic-based resin such as a homopolymer or a copolymer of di(metha)acrylate of (brominated) bisphenol A, or a polymer and a copolymer of urethane-modified monomers of (brominated) bisphenol A mono(metha)acrylate; polyester, especially polyethylene terephthalate, polyethylene naphthalate, and unsaturated polyester; acrylonitrile-styrene copolymer; polyvinyl chloride; polyurethane; an epoxy resin; polyarylate; polyether sulphone; polyether ketone; cycloolefin polymer (product name: ARTON or ZEONOR); and cycloolefin copolymer. It is also possible to use an aramid-based resin in which heat resistance is taken into consideration.

In a case where the plastic material is used for each of the bases 3 and 9, in order to further improve surface energy, coating properties, slip properties, flatness, etc. of a plastic surface, a basecoat layer may be provided as a surface processing. Examples of the basecoat layer may include an organo alkoxy metal compound, polyester, acryl-modified polyester, and polyurethane. Alternatively, in order to achieve an effect similar to an effect achieved by provision of the basecoat layer, a corona discharge and a UV application processing may be performed on the surface of each of the bases 3 and 9.

In a case where each of the bases 3 and 9 is a plastic film, each of the bases 3 and 9 may be obtained, for example, by a method of stretching the resin described above, by a method of diluting the resin described above in a solvent, then forming the resultant into a film, and drying the formed film, etc. Moreover, each of the bases 3 and 9 may preferably have a thickness that is appropriately selected depending on an application of the conductive optical device 1, and may have a thickness from about 25 μm to about 50 μm, for example.

Each of the bases 3 and 9 may have, for example, a sheet-like shape, a plate-like shape, or a block-like shape. The shape of each of the bases 3 and 9 is, however, not limited to these shapes in particular. It is defined herein that a sheet encompasses a film.

(Structure)

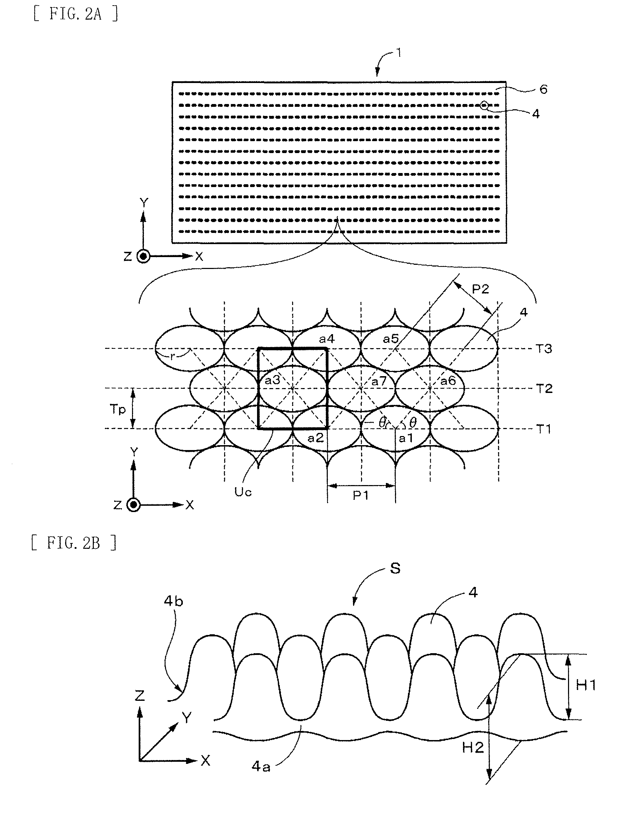

FIG. 2A is a plan view illustrating an example of a surface of an optical layer formed with the plurality of structures 4, and also illustrating a part of the optical layer surface in an enlarged manner. FIG. 2B is a perspective view illustrating a part of the optical layer surface illustrated in FIG. 2A in an enlarged manner. Two directions that are orthogonal to each other in a principal surface of the conductive optical device 1 are referred to as an X-axis direction and a Y-axis direction, and a direction perpendicular to the principal surface is referred to as a Z-axis direction below. The structures 4 may each have a convex shape or a concave shape with respect to the surface of the base 3, and may be arrayed two-dimensionally with respect to the surface of the base 3, for example. The structures 4 may be preferably arrayed two-dimensionally in a cyclic manner at a short arrangement pitch that is equal to or shorter than a wavelength band of light for the purpose of reduction in reflection. By two-dimensionally arraying the structures 4 in such a manner, a two-dimensional wavy surface may be formed on the surface of the base 3.

The arrangement pitch refers herein to an arrangement pitch P1 and an arrangement pitch P2. Incidentally, description is provided later of the arrangement pitches P1 and P2. The wavelength band of light for the purpose of reduction in reflection may be, for example, a wavelength band of ultraviolet light, a wavelength band of visible light, or a wavelength band of infrared light. Herein, the wavelength band of ultraviolet light refers to a wavelength band from 10 nm to 360 nm, the wavelength band of visible light refers to a wavelength band from 360 nm to 830 nm, and the wavelength band of infrared light refers to a wavelength band from 830 nm to 1 mm. Specifically, the arrangement pitch may be preferably from 175 nm to 350 nm both inclusive. When the arrangement pitch is shorter than 175 nm, fabrication of the structures 4 tends to be difficult. On the other hand, when the arrangement pitch is over 350 nm, diffraction of visible light tends to be caused.

The structures 4 have an arrangement form so as to form a plurality of lines of tracks T1, T2, T3, ... (hereinafter, may be collectively referred to as "track T") on the surface of the base 3. In the technology, the track refers to a part in which the structures 4 are continuously provided in a line. Further, a line direction (inter-line direction) refers to a direction that is orthogonal to the direction (X direction) in which the track extends in the formation surface of the base 3. A shape of the track T may be a linear shape, an arc-like shape, or the like, and the tracks T having such a shape may be wobbled. By thus causing the tracks T to be wobbled, it is possible to suppress occurrence of unevenness in appearance.

In a case where the tracks T are wobbled, the wobbles of the respective tracks T on the base 3 may be preferably synchronized with one another. In other words, the wobbles may be preferably synchronized wobbles. By thus synchronizing the wobbles, it is possible to retain a unit lattice pattern of the hexagonal lattice pattern or the quasi-hexagonal lattice pattern and to retain a high filling rate. The wobbled track T may have a waveform such as a sine curve or a triangle wave, for example. The waveform of the wobbled track T is not limited to a cyclic waveform and may be a non-cyclic waveform. The wobbled track T may have a wobble amplitude that is selected to be about ±10 nm, for example.

The structures 4 may be arranged, for example, at positions that are shifted by a half pitch between the two adjacent tracks T. Specifically, between the two adjacent tracks T, the structures 4 arrayed in one track (for example, T1) are respectively arranged at intermediate positions (positions each being shifted by a half pitch) between the structures 4 arrayed in the other track (for example, T2). As a result, as illustrated in FIG. 2A, the structures 4 are arranged so as to form a hexagonal lattice pattern or a quasi-hexagonal lattice pattern in which centers of the structures 4 are positioned at respective points a1 to a7 across the three adjacent lines of tracks (T1 to T3).

Herein, the hexagonal lattice pattern refers to a regular hexagonal lattice pattern. The quasi-hexagonal lattice pattern is different from the regular hexagonal lattice pattern, and refers to a distorted regular hexagonal lattice pattern. To give an example, in a case where the structures 4 are arranged in a line, the quasi-hexagonal lattice pattern may refer to a hexagonal lattice pattern that is obtained by stretching the regular hexagonal lattice pattern in a linear arraying direction (track direction) and distorting the stretched pattern. In a case where the structures 4 are arrayed to be wobbled, the quasi-hexagonal lattice pattern may refer to a hexagonal lattice pattern that is obtained by distorting the regular hexagonal lattice pattern as a result of the wobbled array of the structures 4, or to a hexagonal lattice pattern that is obtained by stretching the regular hexagonal lattice pattern in the linear arraying direction (track direction), distorting the stretched pattern, and further distorting the resultant as a result of the wobbled array of the structures 4.

In a case where the structures 4 are arranged so as to form a quasi-hexagonal lattice pattern, the arrangement pitch P1 (for example, a distance between a1 and a2) of the structures 4 in the same track (for example, T1) may be preferably longer than the arrangement pitch of the structures 4 between the two adjacent tracks (for example, T1 and T2), that is, the arrangement pitch P2 (for example, a distance between a1 and a7 and a distance between a2 and a7) of the structures 4 in a ±θ direction with respect to the extending direction of the track, as illustrated in FIG. 2A. By thus arranging the structures 4, it is possible to further improve filling density of the structures 4.

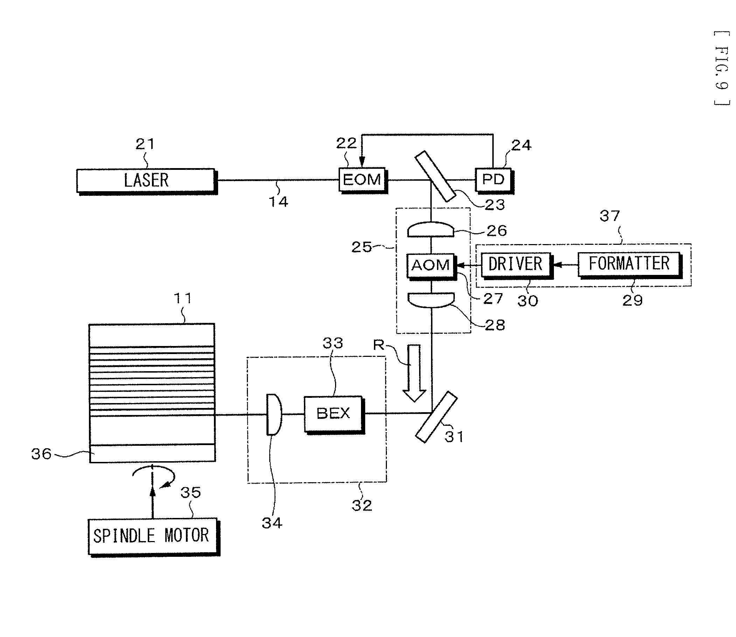

Examples of a specific shape of each of the structures 4 may include a cone shape, a column shape, a needle-like shape, a hemi-sphere shape, a hemi-ellipsoid shape, and a polygon shape. However, the specific shape of each of the structures 4 is not limited to these shapes, and other shape may be employed therefor. Examples of the cone shape may include a cone shape having a sharp apex portion, a cone shape having a flat apex portion, and a cone shape having an apex portion that has a convex or concave curved surface. In view of electric reliability, the cone shape having the apex portion that has the convex curved surface may be preferable. However, the shape of each of the structures 4 is not limited to these shapes. Examples of the cone shape having the apex portion that has the convex curved surface may include a quadric surface such as a paraboloid. Alternatively, a conic surface of the cone shape may be curved to have a concave shape or a convex shape. In a case where a roll-shaped master is fabricated with the use of a roll-shaped master exposure apparatus (see FIG. 9) described later, preferably, an elliptical cone shape having an apex portion that has a convex curved surface or a truncated elliptical cone shape having a flat apex portion may be employed as the shape of the structure 4, and a major-axis direction of an ellipse forming a bottom surface thereof may coincide with the extending direction of the track T.

In view of improvement in optical characteristics, it may be preferable to employ a cone shape having inclination that is moderate at an apex portion and gradually becomes sharper from a center portion toward a bottom portion thereof. Further, in view of improvement in the optical characteristics, it may be preferable to employ a cone shape having inclination that is sharper at a center portion thereof than at a bottom portion and an apex portion thereof, or a cone shape that has a flat apex portion. In a case where the structure 4 has an elliptical cone shape or a truncated elliptical cone shape, the bottom surface of the structure 4 may preferably have a major-axis direction that is parallel to the extending direction of the track.

The structure 4 may preferably have, in a peripheral portion of the bottom portion thereof, a curved surface portion 4b having a height that is moderately decreased in a direction from the apex portion to a lower portion. One reason for this is because it is thereby made easier to peel off the conductive optical device 1 from the master or the like in a process of manufacturing the conductive optical device 1. It is to be noted that the curved surface portion 4b may be provided only in a part of the peripheral portion of the structure 4; however, the curved surface portion 4b may be preferably provided in all of the peripheral portion of the structure 4 in view of improvement of the peeling-off characteristics described above.

A protrusion portion 4a may be preferably provided in a part or all of circumference of the structures 4. One reason for this is because such provision of the protrusion portion 4a suppresses reflectance to be low even when the filling rate of the structures 4 is low. In view of easiness in molding, the protrusion portion 4a may be preferably provided between the adjacent structures 4. Moreover, a surface of a part or all of the circumference of the structures 4 may be roughened to form minute asperities thereon. Specifically, for example, a surface between the adjacent structures 4 may be roughened to form minute asperities. Alternatively, a minute hole may be formed in the surface of the structures 4, for example, at the apex portions of the structures 4.

It is to be noted that, in FIGs. 2A and 2B, the respective structures 4 have the same size, the same shape, and the same height. However, the shapes of the structures 4 are not limited thereto, and the structures 4 having two or more sizes, two or more shapes, and two or more heights may be formed on the surface of the base.

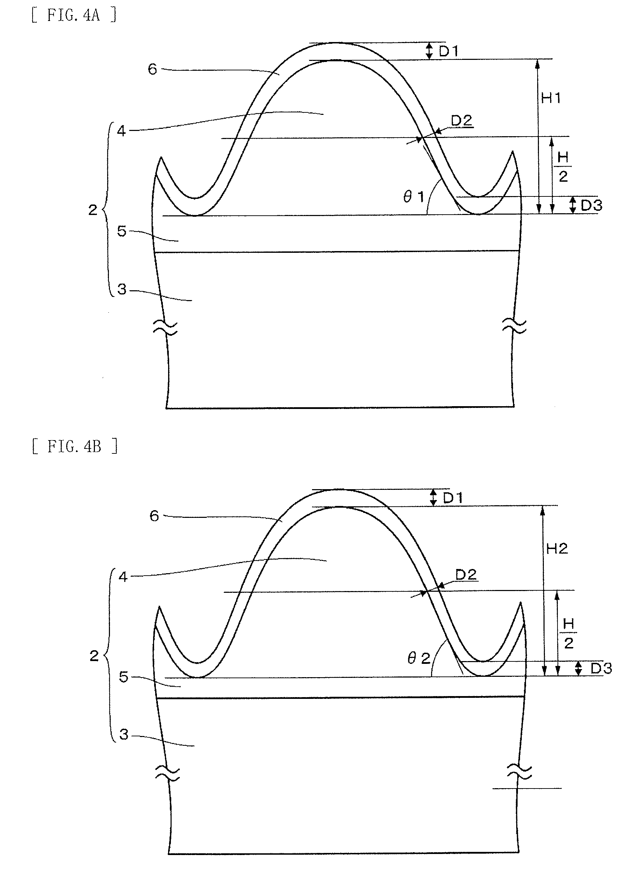

FIG. 4A is a schematic view illustrating a height of the structure 4 in the extending direction of the track. FIG. 4B is a schematic view illustrating a height of the structure 4 in the line direction of the track. The height of the structure 4 may preferably have anisotropy in an in-plane direction, because both conductivity and optical characteristics are achieved thereby. More specifically, the height H1 of the structure 4 in the extending direction of the track may be preferably smaller than the height H2 of the structure 4 in the line direction. In other words, the heights H1 and H2 of the structure 4 may preferably satisfy a relationship of H1 < H2.

A surface of the structure 4 may preferably form an inclined surface having an inclination angle that is different depending on an in-plane direction of the surface of the base 3, because both conductivity and optical characteristics are achieved thereby. More specifically, an inclination angle $\theta1$ of the structure 4 in the extending direction of the track may be preferably more moderate than an inclination angle $\theta2$ of the structure 4 in the line direction.

It is to be noted that the aspect ratios of the structures 4 may not be necessarily the same, and the respective structures 4 may be configured to have a certain height distribution. By thus providing the structures 4 having a height distribution, it is possible to reduce wavelength dependency of the optical characteristics. Accordingly, it is possible to achieve the conductive optical device 1 having superior optical characteristics.

The height distribution used herein refers to that the structures 4 having two or more heights are provided on the surface of the base 3. For example, the structure 4 having a height that is used as a reference and the structure 4 having a height that is different from the height of the previously-mentioned structure 4 may be provided on the surface of the base 3. In this case, the structures 4 having the height different from the reference height may be provided cyclically or non-cyclically (randomly) on the surface of the base, for example. Examples of a direction of the cycle may include the extending direction of the track and the line direction thereof.

The structure 4 may have a refractive index in a range, preferably from 1.53 to 1.8 both inclusive, more preferably from 1.53 to 1.75 both inclusive, further more preferably from 1.55 to 1.75 both inclusive, and most preferably from 1.6 to 1.71 both inclusive. When the refractive index of the structure 4 is lower than 1.53, non-visibility ΔY tends to be degraded. On the other hand, when the refractive index of the structure 4 is over 1.8, interface reflection between the resin material forming the structure 4 and the base 3 becomes larger, which results in decrease in transmittance.
It is to be noted that the aspect ratio in the technology is defined by the following expression:

$$\text{Aspect ratio} = H/P$$

where H is the height of the structure, and P is an average arrangement pitch (average cycle).
Here, the average arrangement pitch P is defined by the following expression:

$$\text{Average arrangement pitch } P = (P1 + P2 + P2) / 3$$

where P1 is the arrangement pitch in the extending direction of the track (track extending direction cycle), and P2 is the arrangement pitch in the $\pm\theta$ direction with respect to the extending direction of the track ($\theta$-direction cycle) where $\theta$ = 60°-$\delta$, and $\delta$ may be preferably $0° < \delta \leq 11°$, and more preferably $3° \leq \delta \leq 6°$.
Moreover, in a case where the structures 4 are arrayed in a hexagonal lattice pattern or a quasi-hexagonal lattice pattern, the height H of the structure 4 is determined as the height of the structure 4 in the line direction. The height of the structure 4 is represented by the height in the line direction because the height of the structure 4 in the extending direction (X direction) of the track is smaller than the height thereof in the line direction (Y direction), and further, the height of the structure 4 in a portion in a direction other than the extending direction of the track is almost the same as the height in the line direction. However, in a case where the structure 4 is a concave portion, the height H of the structure 4 in the above expression is determined as a depth H of the structure 4.
A ratio P1/P2 may preferably satisfy a relationship of $1.00 \leq P1/P2 \leq 1.1$ or $1.00 < P1/P2 \leq 1.1$ where P1 is the arrangement pitch of the structures 4 in the same track, and P2 is the arrangement pitch of the structures 4 between two adjacent tracks. By thus setting the numerical range, it is possible to improve the filling rate of the structures 4 each having an elliptical cone shape or a truncated elliptical cone shape, and to therefore improve the optical characteristics.
The filling rate of the structures 4 on the surface of the base may be in a range of 65% or higher, preferably 73% or higher, and more preferably 86% or higher, with 100% as an upper limit. By thus setting the filling rate in such ranges, it is possible to improve the optical characteristics. In order to improve the filling rate, it may be preferable to bond lower portions of the adjacent structures 4 or to distort the structures 4 by adjusting ellipticity of the bottom surface of the structures.
Herein, the filling rate (average filling rate) of the structures 4 is a value determined as follows.
First, a surface of the conductive optical device 1 is shot in Top View with the use of a scanning electron microscope (SEM). Next, a unit lattice Uc is randomly selected from the shot SEM photograph and the arrangement pitch P1 of the unit lattice Uc and a track pitch Tp are measured (see FIG. 2A). Further, the area S of the bottom surface of the structure 4 positioned at the center of the unit lattice Uc is measured by an image processing. Subsequently, the measured arrangement pitch P1, track pitch Tp, and area S of the bottom surface are used to determine the filling rate by the following expressions.

$$\text{Filling rate} = (S(\text{hex.})/S(\text{unit}))\times 100$$

$$\text{Unit lattice area: } S(\text{unit}) = P1\times 2Tp$$

Area of bottom surface of structure present inside unit lattice: S(hex.) = 2S
The processing of calculating the filling rate described above is performed on unit lattices at ten places that are randomly selected from the shot SEM photograph. Subsequently, the measurement values are simply averaged (arithmetic average) to determine an average value of the filling rates, and the determined average value is used as the filling rate of the structures 4 on the surface of the base.
The filling rate in a case where the structures 4 overlap one another or in a case where a sub-structure such as the protrusion portion 4a is provided between the structures 4 is allowed to be determined by a method of judging an area ratio using a portion corresponding to 5% the height of the structure 4 as a threshold.

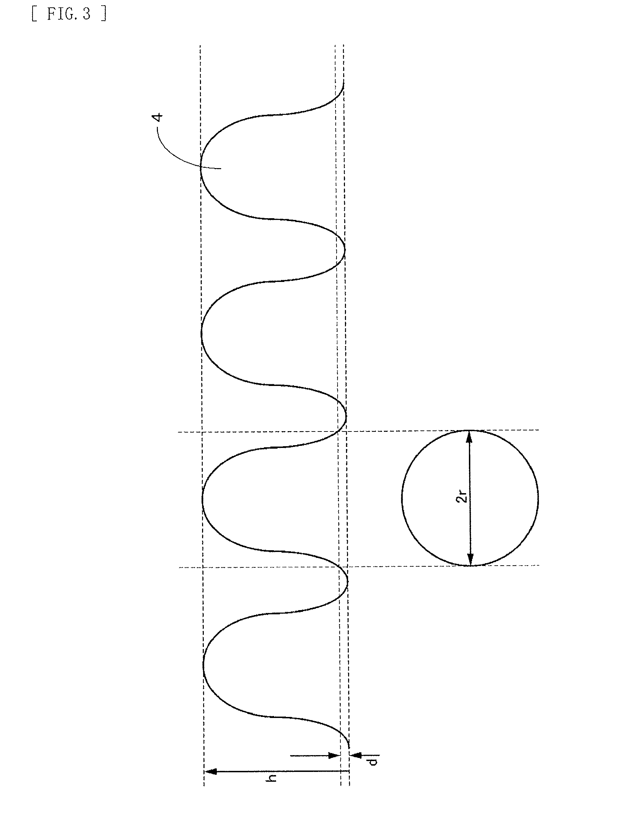

FIG. 3 is a diagram for describing a method of calculating the filling rate in a case where a boundary between the structures 4 is vague. In the case where the boundary between the structures 4 is vague, the filling rate is determined, using a portion corresponding to 5% the height h of the structure 4 (= (d/h)×100) as a threshold as illustrated in FIG. 3, by converting a diameter of the structure 4 by the height d based on a cross section SEM observation. In a case where the bottom surface of the structure 4 is an ellipse, a similar processing is performed using a major axis and a minor axis thereof.

The structures 4 may be preferably connected to one another so that the lower portions thereof overlap one another. Specifically, respective parts or all of the lower portions of the structures 4 in an adjacent relationship may preferably overlap each other, and may preferably overlap each other in the track direction, the θ direction, or both. By thus causing the lower portions of the structures 4 to overlap one another, it is possible to improve the filling rate of the structures vb 4. The structures may preferably overlap one another in portions having a height that is 1/4 or less of the maximum value of the wavelength band of light under use environment based on conversion into an optical path length taking into consideration a refractive index. Specifically, a height (optical path length) of the portions at which the structures overlap one another may be preferably 1/4 or less of the maximum value of the wavelength band of light under the use environment. One reason for this is because superior optical characteristics are achieved thereby.

A ratio ((2r/P1)×100) of a diameter 2r to the arrangement pitch P1 may be in a range of preferably 85% or higher, more preferably 90% or higher, and further more preferably 95% or higher. One reason for this is because, by setting such ranges, it is possible to improve the filling rate of the structures 4, and to thereby improve the optical characteristics. When the ratio ((2r/P1)×100) becomes larger and the overlapped portions of the structures 4 become excessively large, the optical characteristics tend to be degraded. For this reason, it may be preferable to set an upper limit of the ratio ((2r/P1)×100) so that the structures are bonded to one another in portions having a height that is 1/4 or less of the maximum value of the wavelength band of light under the use environment based on conversion into an optical path length taking into consideration a refractive index. Specifically, the upper limit of the ratio ((2r/P1)×100) may be preferably set so that the height (optical path length) of the bonded portions of the structures becomes 1/4 or less of the maximum value of the wavelength band of light under the use environment. Here, the arrangement pitch P1 is an arrangement pitch of the structures 4 in the track direction as illustrated in FIG. 2A, and the diameter 2r is a diameter of the bottom surface of the structure in the track direction as illustrated in FIG. 2A. It is to be noted that the diameter 2r is a diameter in a case where the bottom surface of the structure is a circle, and the diameter 2r is a major diameter in a case where the bottom surface of the structure is an ellipse.

In a case where the structures 4 form a quasi-hexagonal lattice pattern, ellipticity e of the bottom surface of the structures may preferably satisfy 100% < e < 150%. One reason for this is because, by thus setting the range, it is possible to improve the filling rate of the structures 4 and to thereby achieve superior optical characteristics.

(Transparent Conductive Layer)

The transparent conductive layer 6 provided on the surface side of the base 3 may preferably have a shape that follows along a surface shape of the structures 4. The transparent conductive layer 6 may be, for example, an organic transparent conductive layer or an inorganic transparent conductive layer. The organic transparent conductive layer may preferably contain a conductive polymer or carbon nanotube as a main component. Usable examples of the conductive polymer may include polythiophene-based, polyaniline-based, and polypyrrole-based conductive polymer materials, and the polythiophene-based conductive polymer material may be preferably used. As the polythiophene-based conductive polymer material, a PEDOT/PSS-based material in which PEDOT (polyethylenedioxythiophene) is doped with PSS (polystyrene sulfonate) may be preferably used.

The inorganic transparent conductive layer may preferably contain transparent oxide semiconductor as a main component. Usable examples of the transparent oxide semiconductor may include: a binary compound such as $SnO_2$, $InO_2$, ZnO, and CdO; a ternary compound including one or more elements selected from Sn, In, Zn, and Cd that are constituent elements of the binary compound; and a multi-component (complex) oxide. Specific examples of the transparent oxide semiconductor may include indium tin oxide (ITO), zinc oxide (ZnO), aluminum-doped zinc oxide (AZO ($Al_2O_3$, ZnO)), SZO, fluorine-doped tin oxide (FTO), tin oxide ($SnO_2$), gallium-doped zinc oxide (GZO), and indium zinc oxide (IZO ($In_2O_3$, ZnO)). In particular, indium tin oxide (ITO) may be preferable in view of high reliability and low resistivity. The material configuring the inorganic transparent conductive layer may preferably have a mixed state of an amorphous state and a polycrystalline state in view of improvement in conductivity.

In view of productivity, the material configuring the transparent conductive layer 6 may be preferably a material that includes, as a main component, one or more selected from the group consisting of a conductive polymer, a metal nanoparticle, and carbon nanotube. By containing such a material as the main component, it is possible to easily form the transparent conductive layer 6 by wet coating without using an expensive vacuum apparatus or the like.

Where D1 is a thickness of the transparent conductive layer 6 at the apex portion of the structure 4, D2 is a thickness of the transparent conductive layer 6 at the inclined surface of the structure 4, and D3 is a thickness of the transparent conductive layer 6 between the structures, the thicknesses D1, D2, and D3 may preferably satisfy a relationship of D1 > D3, and may more preferably satisfy a relationship of D1 > D3 > D2. A ratio (D3/D1) of the thickness D3 of the transparent conductive layer 6 between the structures to the thickness D1 of the transparent conductive layer 6 at the apex portion of the structure 4 may be preferably in a range of 0.8 or smaller, and may be more preferably in a range of 0.7 or smaller. By allowing the ratio (D3/D1) to be 0.8 or smaller, it is possible to improve the optical characteristics compared to those in a case where the ratio (D3/D1) is 1. Accordingly, it is possible to reduce a reflectance difference ∆R between reflectance of the first region $R_1$ formed with the transparent conductive layer 6 and reflectance of the second region $R_2$ formed with no transparent conductive layer 6. In other words, it is possible to suppress visibility of the transparent conductive layer 6 having a predetermined pattern.

It is to be noted that the thickness D1 of the transparent conductive layer 6 at the apex portion of the structure 4, the thickness D2 of the transparent conductive layer 6 at the inclined surface of the structure 4, and the thickness D3 of the transparent conductive layer 6 between the structures are equal to the thickness D1 of the transparent conductive layer 6 at a position at which the corrugated surface S is highest, the thickness D2 of the transparent conductive layer 6 at the inclined surface of the corrugated surface S, and the thickness D3 of the transparent conductive layer 6 at a position at which the corrugated surface S is lowest, respectively.

The thickness D1 of the transparent conductive layer 6 at the apex portion of the structure 4 may be in a range that may be preferably 47 nm or smaller, more preferably from 20 nm to 47 nm both inclusive, and further more preferably from 20 nm to 40 nm both inclusive. When the thickness D1 of the transparent conductive layer 6 at the apex portion of the structure 4 is smaller than 20 nm, conductivity tends to be decreased. On the other hand, when the thickness D1 of the transparent conductive layer 6 at the apex portion of the structure 4 is over 47 nm, in a case where the conductive optical device 1 has a film shape, flexibility of the film-shaped conductive optical device 1 tends to be decreased.

The thicknesses D1, D2, and D3 of the transparent conductive layer 6 described above are determined as follows.

First, the conductive optical device 1 is cut in the extending direction of the track so as to include the apex portions of the structures 4, and a cross section thereof is shot by a transmission electron microscope (TEM). Next, the thickness D1 of the transparent conductive layer 6 at the apex portion of the structure 4 is measured based on the shot TEM photograph. Subsequently, the thickness D2 at a position having a height (H/2) half of the height of the structure 4 out of the positions on the inclined surface of the structure 4 is measured. Subsequently, the thickness D3 at a position at which the depth of the concave portion is deepest out of the positions of the concave portion between the structures is measured.

It is to be noted that whether or not the thicknesses D1, D2, and D3 of the transparent conductive layer 6 satisfy the above-described relationship is allowed to be confirmed based on the thicknesses D1, D2, and D3 of the transparent conductive layer that are thus determined.

A surface resistance of the transparent conductive layer 6 may be preferably in a range of 180 Ω/□ or lower. When the surface resistance thereof is over 180 Ω/□, an issue may be caused in conductivity when the conductive optical device 1 is applied to a touch panel. Here, the surface resistance of the transparent conductive layer 6 is determined by a four point prove method (JIS K 7194).

(Attaching Layer)

Usable examples of the attaching layer 8 may include acrylic-based, rubber-based, and silicon-based adhesive agents, and the acrylic-based adhesive agent may be preferable in view of transparency.

(Metal Layer)

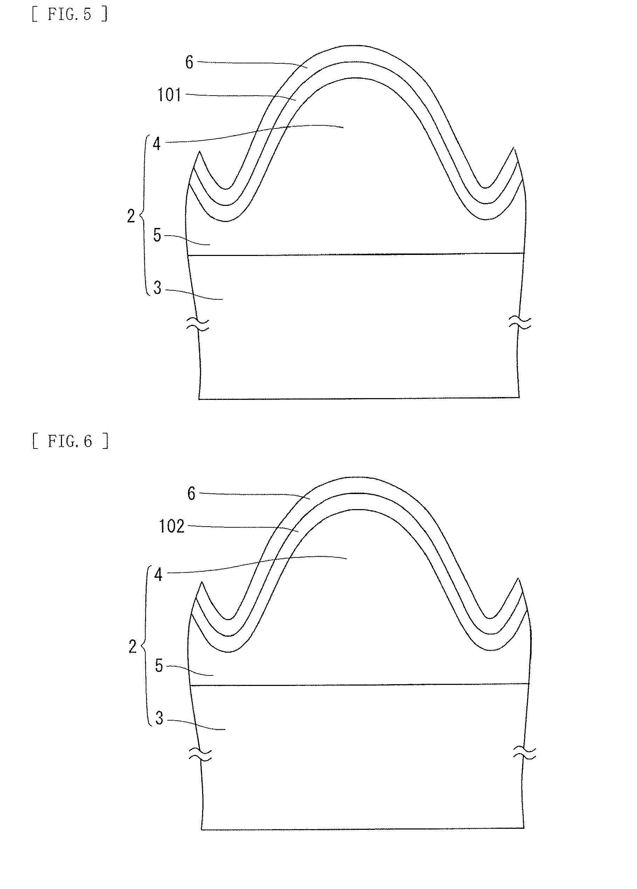

FIG. 5 is a schematic view illustrating a modification of the configuration of the conductive optical device according to the first embodiment of the technology, and corresponds to FIG. 4A. In view of decrease in surface resistance, a metal layer 101 (conductive layer) may be further provided as an underlayer of the transparent conductive layer 6 between the structures 4 and the transparent conductive layer 6. It is thereby possible to decrease resistivity, and to make the transparent conductive layer 6 thinner. Alternatively, it is thereby possible to supplement conductivity rate in a case where a sufficient value of conductivity rate is not achieved when only the transparent conductive layer 6 is used. A thickness of the metal layer 101 is not particularly limited, but may be selected to be, for example, about several nanometers. Because the metal layer 101 has a high conductivity rate, it is possible to achieve sufficient surface resistance with the use of the metal layer 101 having a thickness of several nanometers. Also, when the thickness of the metal layer 101 is about several nanometers, the metal layer 101 may give little optical influence such as absorption and reflection. The material configuring the metal layer 101 may be preferably a metal-based material having high conductivity. Examples of such a material may include one or more selected from the group consisting of Ag, Pt, Al, Au, Cu, Ti, Nb, and impurity-added Si. However, taking into consideration high conductivity and performance in use, Ag may be preferable. In a case where the surface resistance is allowed to be secured only with the use of the metal layer 101 but the metal layer 101 is extremely thin, the metal layer 101 may have an island-like structure, which causes difficulty in securing conductivity. In this case, formation of the transparent conductive layer 6 above the metal layer 101 is important also in order to electrically connect the island-like metal layers 101. The metal layer 101 may preferably have a shape that follows along the surface shape of the structures 4.

(Dielectric Layer)

FIG. 6 is a schematic view illustrating another modification of the configuration of the conductive optical device according to the first embodiment of the technology, and corresponds to FIG. 4A.

A dielectric layer 102 as a barrier layer may be further provided between the structures 4 and the transparent conductive layer 6. Usable examples of a material of the dielectric layer 102 may include a metal oxide. Usable examples of the metal oxide may include an oxide of Si. The dielectric layer 102 may preferably have a shape that follows along the surface shape of the structures 4. In a case where both of the dielectric layer 102 and the metal layer 101 are provided between the structures 4 and the transparent conductive layer 6, the dielectric layer 102 and the metal layer 101 may be preferably provided so that the dielectric layer 102 is provided on the structure 4 side and the metal layer 101 is provided on the transparent conductive layer 6 side.

[Optical Characteristics]

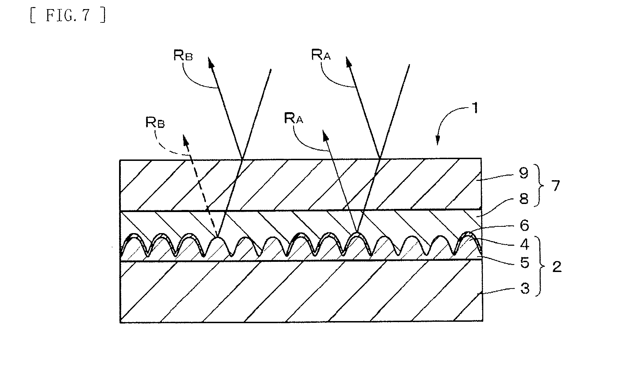

Optical characteristics of the conductive optical device according to the first embodiment are described below with reference to FIG. 7.

The reflectance difference $\Delta R$ of the conductive optical device 1 is expressed by the following expression:

$$\Delta R = R_A - R_B$$

where $R_A$ is the reflectance of the first region $R_1$ formed with the transparent conductive layer 6, and $R_B$ is the reflectance of the second region $R_2$ formed with no transparent conductive layer 6. Here, the values of the reflectance $R_A$ and the reflectance $R_B$ are values in a state where the optical layer 7 is formed on the transparent conductive layer 6.

Non-visibility $\Delta Y$ of the conductive optical device 1 is expressed by the following expression using the reflectance difference $\Delta R$ described above:

$$\Delta Y\ [\%] = \Delta R \times V$$

where V is spectral luminous efficacy.

In the state where the optical layer 7 is formed on the transparent conductive layer 6, the non-visibility $\Delta Y$ (= $\Delta R \times V$) may be in a range of, preferably 0.3% or lower, more preferably 0.2 or lower, and most preferably 0.1 or lower. When the non-visibility $\Delta Y$ is over 0.3%, a wiring pattern tends to be easier to be seen.

In the state where the optical layer 7 is formed on the transparent conductive layer 6, a refractive index x and an aspect ratio y of each of the structures 4 satisfy the following relational expressions (1) and (2). By allowing the refractive index x and the aspect ratio y to satisfy the relationship, it is possible to cause the non-visibility $\Delta Y$ to be in a range of 0.3% or lower.

$$y \geq -1.785x + 3.238 \qquad (1)$$

$$y \leq 0.686 \qquad (2)$$

In the state where the optical layer 7 is formed on the transparent conductive layer 6, the refractive index x and the aspect ratio y of each of the structures 4 satisfy the following relational expressions (2) and (3). By allowing the refractive index x and the aspect ratio y to satisfy the relationship, it is possible to cause the non-visibility $\Delta Y$ to be in a range of 0.2% or lower.

$$y \geq -1.352x + 2.636 \qquad (3)$$

$$y \leq 0.686 \qquad (2)$$

[Configuration of Roll-shaped Master]

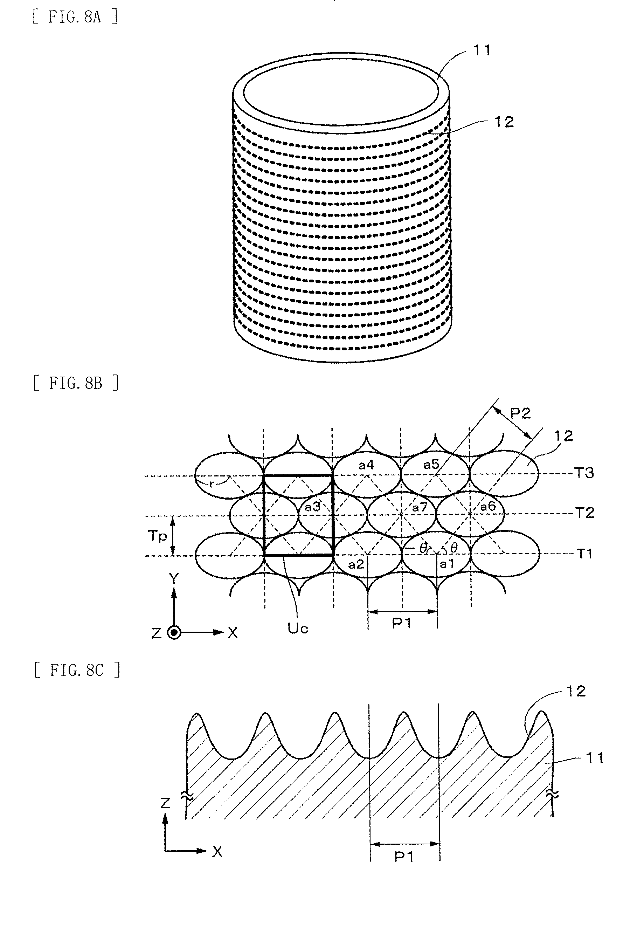

FIG. 8A is a perspective view illustrating an example of a configuration of a roll-shaped master. FIG. 8B is a plan view illustrating a part of the roll-shaped master illustrated in FIG. 8A in an enlarged manner. FIG. 8C is a cross-sectional view taken along the tracks T1, T3, ... illustrated in FIG. 8B. A roll-shaped master 11 is a master for fabricating the conductive optical device 1 having the above-described configuration, more specifically, a master for forming the structures 4 on the surface of the base described above. The roll-shaped master 11 may have, for example, a cylinder shape or a hollow cylinder shape, and a cylindrical surface or a hollow cylindrical surface thereof is used as a formation surface for forming the structures 4 on the surface of the base. A plurality of structures 12 are arrayed two-dimensionally on the formation surface. Each of the structures 12 may have, for example, a concave shape with respect to the formation surface. The material of the roll-shaped master 11 may be, for example, glass, but is not particularly limited to this material.

The structures 12 arranged on the formation surface of the roll-shaped master 11 and the structures 4 arranged on the surface of the base 3 described above are in a reverse concave-convex relationship. Specifically, the shape, the array, the arrangement pitch, etc. of the structures 12 on the roll-shaped master 11 are similar to those of the structures 4 on the base 3.

[Configuration of Exposure Apparatus]

FIG. 9 is a schematic view illustrating an example of a configuration of a roll-shaped master exposure apparatus for fabricating the roll-shaped master. The roll-shaped master exposure apparatus is configured based on an optical disk recording apparatus.

A laser (laser light source 21) is a light source for exposing a resist deposited on a surface of the roll-shaped master 11 as a recording medium, and may perform oscillation of recording laser light 14 having a wavelength $\lambda$ of 266 nm, for example. The laser light 14 emitted from the laser light source 21 travels straightly on as a parallel beam and enters an electro-optical device (EOM: Electro Optical Modulator) 22. The laser light 14 that has passed through the electro-optical device 22 is reflected by a mirror 23 and is guided to a modulation optical system 25.

The mirror 23 is configured of a polarization beam splitter, and has a function of reflecting one polarization component and causing the other polarization component to pass therethrough. The polarization component that has passed through the mirror 23 is received by a photodiode (PD) 24, and the electro-optical device 22 is controlled based on a light-receiving signal to perform phase modulation on the laser light 14.

In the modulation optical system 25, the laser light 14 is condensed by a condenser lens 26 on an acousto-optic device (AOM: Acousto-Optic Modulator) 27 made of glass ($SiO_2$) or the like. After the laser light 14 is modulated in intensity and diverged by the acousto-optic device 27, the modulated and diverged laser light 14 is made a parallel beam by a lens 28. The laser light 14 emitted from the modulation optical system 25 is reflected by a mirror 31 and is guided horizontally and in parallel onto a moving optical table 32.

The moving optical table 32 includes a beam expander (BEX) 33 and an objective lens 34. The laser light 14 guided to the moving optical table 32 is shaped into a desirable beam shape by the beam expander 33, and is then applied onto a resist layer on the roll-shaped master 11 via the objective lens 34. The roll-shaped master 11 is placed on a turntable 36 connected to a spindle motor 35. Further, while causing the roll-shaped master 11 to rotate and causing the laser light 14 to move in a height direction of the roll-shaped master 11, the laser light 14 is intermittently applied onto the resist layer. Thus, an exposure process of the resist layer is performed. The formed latent image has an almost ellipse shape that has a major axis in a circumferential direction. The movement of the laser light 14 is performed in response to movement of the moving optical table 32 in a direction indicated by an arrow R.

The exposure apparatus includes a control mechanism 37 for forming, on the resist layer, a latent image corresponding to the two-dimensional hexagonal lattice pattern or the two-dimensional quasi-hexagonal lattice pattern illustrated in FIG. 2A. The control mechanism 37 includes a formatter 29 and a driver 30. The formatter 29 includes a polarity reversion section, and the polarity reversion section controls a timing of application of the laser light 14 onto the resist layer. The driver 30 controls the acousto-optic device 27 upon receiving an output of the polarity reversion section.

In the roll-shaped master exposure apparatus, a polarity reversion formatter signal and a rotation controller are synchronized to generate a signal for each track so that the two-dimensional patterns are spatially linked, and intensity of the generated signal is modulated by the acousto-optic device 27. By performing patterning at a constant angular velocity (CAV), at an appropriate rotation speed, at an appropriate modulation frequency, at an appropriate feeding pitch, it is possible to record the hexagonal lattice pattern or the quasi-hexagonal lattice pattern.

[Method of Manufacturing Conductive Optical Device]

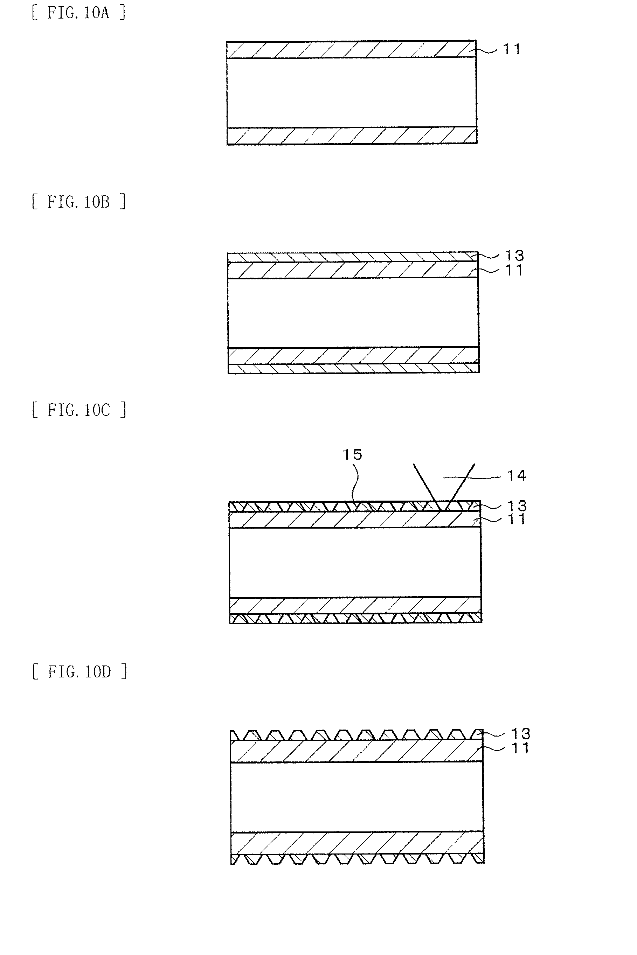

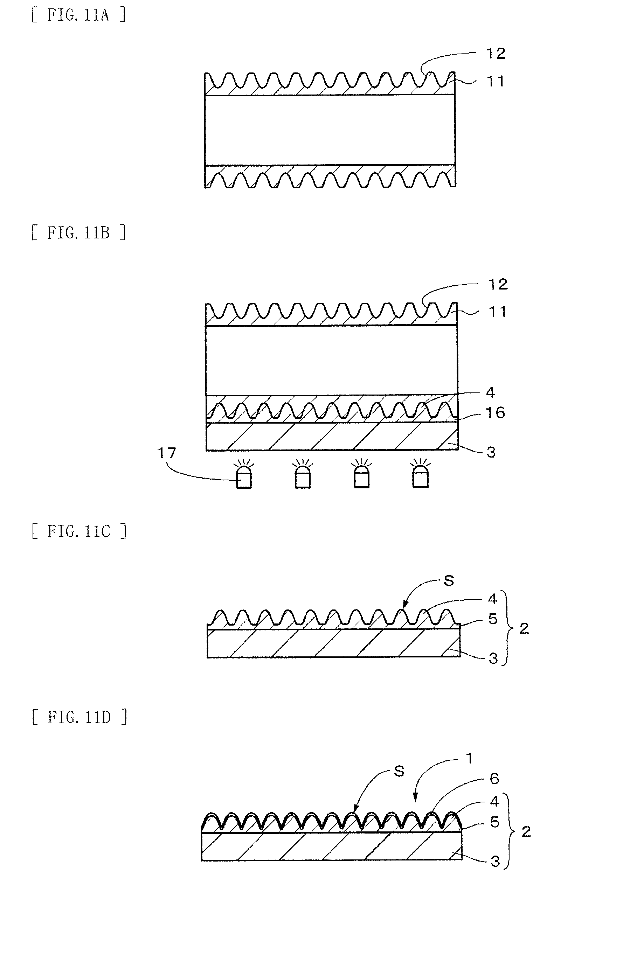

Next, a method of manufacturing the conductive optical device 1 according to the first embodiment of the technology is described with reference to FIGs. 10A to 10D and FIGs. 11A to 11D.

(Resist Deposition Process)

First, as illustrated in FIG. 10A, the roll-shaped master 11 having a cylinder shape or a hollow cylinder shape is prepared. The roll-shaped master 11 may be, for example, a glass master. Next, as illustrated in FIG. 10B, a resist layer 13 is formed on the surface of the roll-shaped master 11. As a material of the resist layer 13, either of an organic resist or an inorganic resist may be used, for example. Usable examples of the organic resist may include a novolac-based resist and a chemically-amplified resist. Further, usable examples of the inorganic resist may include one or more metal compounds.

(Exposure Process)

Subsequently, as illustrated in FIG. 10C, the laser light (exposure beam) 14 is applied onto the resist layer 13 formed on the surface of the roll-shaped master 11. Specifically, while the roll-shaped master 11 is placed on the turntable 36 of the roll-shaped master exposure apparatus illustrated in FIG. 9 to cause the roll-shaped master 11 to rotate, the laser light (exposure beam) 14 is applied onto the resist layer 13. At this time, by intermittently applying the laser light 14 while moving the laser light 14 in a height direction (direction parallel to a center axis of the roll-shaped master 11 having a cylinder shape or a hollow cylinder shape) of the roll-shaped master 11, the entire surface of the resist layer 13 is exposed. As a result, the latent images 15 in correspondence with a trajectory of the laser light 14 may be formed, for example, on the entire surface of the resist layer 13 at a pitch that is about the same as the wavelength of visible light.
The latent images 15 may be arranged, for example, so as to form a plurality of lines of tracks on the surface of the roll-shaped master, and may form a hexagonal lattice pattern or a quasi-hexagonal lattice pattern. The latent images 15 each may have, for example, an ellipse shape that has a major-axis direction in the extending direction of the track.

(Development Process)

Next, for example, a developer may be dropped onto the resist layer 13 while causing the roll-shaped master 11 to rotate, and the resist layer 13 is thus subjected to a development processing. As illustrated in FIG. 10D, a plurality of openings are thereby formed in the resist layer 13. In a case where the resist layer 13 is formed with the use of a positive-type resist, a solubility rate with respect to the developer is increased in an exposed portion exposed by the laser light 14, as compared to in an unexposed portion. Accordingly, as illustrated in FIG. 10D, a pattern in correspondence with the latent images (exposed portion) 15 is formed on the resist layer 13. The pattern of the openings may be, for example, a predetermined lattice pattern such as a hexagonal lattice pattern or a quasi-hexagonal lattice pattern.

(Etching Process)

Next, the surface of the roll-shaped master 11 is subjected to an etching processing using, as a mask, a pattern (resist pattern) of the resist layer 13 formed on the roll-shaped master. Accordingly, as illustrated in FIG. 11A, it is possible to obtain concave portions each having an elliptical cone shape or a truncated elliptical cone shape that has a major-axis direction in the extending direction of the track, that is, the structures 12. Usable examples of the etching may include dry etching and wet etching. At this time, by alternately performing the etching processing and an ashing processing, for example, the pattern of the structures 12 each having a cone shape may be formed.
Thus, the aimed roll-shaped master 11 is achieved.

(Transfer Process)

Next, as illustrated in FIG. 11B, the roll-shaped master 11 is closely attached to a transfer material 16 applied on the base 3, and thereafter, an energy ray such as a ultraviolet ray is applied from an energy ray source 17 onto the transfer material 16 to cure the transfer material 16. Subsequently, the base 3 integrated with the cured transfer material 16 is peeled off. Thus, as illustrated in FIG. 11C, the optical layer 2 that has the structures 4 on the surface of the base is fabricated.

The energy ray source 17 may be any ray source that is capable of emitting an energy ray such as an electron beam, a ultraviolet ray, an infrared ray, a laser light beam, a visible light beam, an ionizing radiation (such as an X-ray, an $\alpha$-ray, a $\beta$-ray, or a $\gamma$-ray), a microwave, or a radio frequency wave, and is not particularly limited.

The transfer material 16 may be preferably an energy-ray-curable resin composite. As the energy-ray-curable resin composite, a ultraviolet-curable resin composite may be preferably used. The energy-ray-curable resin composite may contain filler, a functional additive, or the like on an as-necessary basis.

The ultraviolet-curable resin composite may contain, for example, acrylate and an initiator. The ultraviolet-curable resin composite may contain, for example, a monofunctional monomer, a bifunctional monomer, a multifunctional monomer, or the like. Specifically, the ultraviolet-curable resin composite may be a single material or a mixture of a plurality of materials of the materials described below.

Examples of the monofunctional monomer may include carboxylic acids (such as acrylic acid), hydroxys (such as 2-hydroxyethyl acrylate, 2-hydroxypropyl acrylate, and 4-hydroxybutyl acrylate), alkyl, alicyclics (such as isobutyl acrylate, t-butyl acrylate, isooctyl acrylate, lauryl acrylate, stearyl acrylate, isobonyl acrylate, and cyclohexyl acrylate), and other functional monomers (such as 2-methoxyethyl acrylate, methoxyethylene glycol acrylate, 2-ethoxyethyl acrylate, tetrahydrofurfuryl acrylate, benzyl acrylate, ethylcarbitol acrylate, phenoxyethyl acrylate, N,N-dimethylaminoethyl acrylate, N,N-dimethylaminopropyl acrylamide, N,N-dimethylacrylamide, acryloyl morpholine, N-isopropyl acrylamide, N,N-diethylacrylamide, N-vinylpyrolidone, 2-(perfluorooctyl)ethyl acrylate, 3-perfluorohexyl-2-hydroxypropyl acrylate, 3-perfluorooctyl-2-hydroxypropyl acrylate, 2-(perfluorodecyl)ethyl acrylate, 2-(perfluoro-3-methylbutyl)ethyl acrylate, 2,4,6-tribromophenol acrylate, 2,4,6-tribromophenol methacrylate, 2-(2,4,6-tribromophenoxy)ethyl acrylate, and 2-ethylhexyl acrylate).

Examples of the bifunctional monomer may include tri(propylene glycol)diacrylate, trimethylolpropane diallylether, and urethane acrylate.

Examples of the multifunctional monomer may include trimethylolpropane triacrylate, dipentaerythritol pentaacrylate, dipentaerythritol hexaacrylate, and ditrimethylolpropane tetraacrylate.

Examples of the initiator may include 2,2-dimethoxy-1,2-diphenylethane-1-one, 1-hydroxy-cyclohexylphenylketone, and 2-hydroxy-2-methyl-1-phenylpropane-1-one.

As the filler, for example, either inorganic microparticles or organic microparticles may be used. Examples of the inorganic microparticles may include metal oxide microparticles of $SiO_2$, $TiO_2$, $ZrO_2$, $SnO_2$, $Al_2O_3$, etc.

Examples of the functional additive may include a leveling agent, a surface conditioner, and a defoamer. Examples of the material of the base 3 may include methyl methacrylate (co)polymer, polycarbonate, styrene (co)polymer, methyl methacrylate-styrene copolymer, cellulose diacetate, cellulose triacetate, cellulose acetate butyrate, polyester, polyamide, polyimide, polyether sulfone, polysulfone, polypropylene, polymethylpentene, polyvinyl chloride, polyvinyl acetal, polyether ketone, polyurethane, and glass.

The method of molding the base 3 is not particularly limited, and the base 3 may be that molded by injection molding, extrusion, or casting. A surface processing such as a corona processing may be performed on the surface of the base on an as-necessary basis.

(Transparent Conductive Layer Deposition Process)

Next, as illustrated in FIG. 11D, the transparent conductive layer 6 is deposited on the corrugated surface S of the optical layer 2 formed with the structures 4. When depositing the transparent conductive layer 6, the deposition may be performed while heating the optical layer 2. Usable examples of a method of depositing the transparent conductive layer 6 may include a CVD method (Chemical Vapor Deposition: a technology of precipitating a thin film from a gas phase utilizing a chemical reaction) such as thermal CVD, plasma CVD, and optical CVD, and a PVD method (Physical Vapor Deposition: a technology of forming a thin film by aggregating, on a substrate, a material physically gasified in vacuum) such as vacuum vapor deposition, plasma-assisted vapor deposition, sputtering, and ion plating. Subsequently, an annealing processing may be performed on the transparent conductive layer 6 on an as-necessary basis. As a result, the transparent conductive layer 6 may be in a mixed state of an amorphous state and a polycrystalline state.

(Transparent Conductive Layer Patterning Process)

Next, by patterning the transparent conductive layer 6, for example, by photoetching, the transparent conductive layer 6 having a predetermined pattern is formed.

(Optical Layer Formation Process)

Next, the optical layer 7 may be formed on the corrugated surface S provided with the patterned transparent conductive layer 6 on an as-necessary basis.

Thus, the aimed conductive optical device 1 is achieved.

<2. Second Embodiment>

[Configuration of Conductive Optical Device]

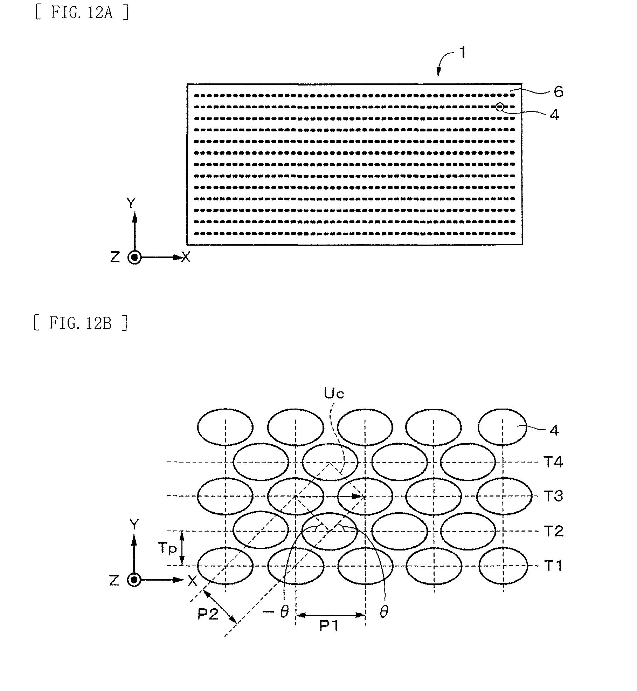

FIG. 12A is a plan view illustrating an example of the optical layer surface of the conductive optical device according to a second embodiment of the technology. FIG. 12B is a plan view illustrating a part of the optical layer surface illustrated in FIG. 12A in an enlarged manner. The conductive optical device 1 of the second embodiment is different from the conductive optical device 1 of the first embodiment in that the structures 4 form a tetragonal lattice pattern or a quasi-tetragonal lattice pattern across three adjacent lines of tracks T.

Herein, the tetragonal lattice pattern refers to a regular tetragonal lattice pattern. The quasi-hexagonal lattice pattern is different from the regular tetragonal lattice pattern and refers to a distorted regular hexagonal lattice pattern. To give an example, in a case where the structures 4 are arranged in a line, the quasi-tetragonal lattice pattern may refer to a tetragonal lattice pattern that is obtained by stretching the regular tetragonal pattern in a linear arraying direction (track direction) and distorting the stretched pattern. In a case where the structures 4 are arrayed to be wobbled, the quasi-tetragonal lattice pattern may refer to a tetragonal lattice pattern that is obtained by distorting the regular tetragonal lattice pattern as a result of the wobbled array of the structures 4, or to a tetragonal lattice pattern that is obtained by stretching the regular tetragonal lattice pattern in the linear arraying direction (track direction), distorting the stretched pattern, and further distorting the resultant as a result of the wobbled array of the structures 4.

The arrangement pitch P1 of the structures 4 in the same track may be preferably longer than the arrangement pitch P2 of the structures 4 between two adjacent tracks. Moreover, where P1 is the arrangement pitch of the structures 4 in the same track and P2 is the arrangement pitch of the structures 4 between two adjacent tracks, P1/P2 may preferably satisfy a relationship of $1.4 < P1/P2 \leq 1.5$. By setting such a numerical range, it is possible to improve the filling rate of the structures 4 each having an elliptical cone shape or a truncated elliptical cone shape, and to therefore improve the optical characteristics. Moreover, the height or the depth of the structure 4 in a direction of 45° or in a direction of about 45° with respect to the track may be preferably smaller than the height or the depth of the structure 4 in the extending direction of the track.

As described above, the arrangement pitch P1 of the structures 4 in the same track may be preferably longer than the arrangement pitch P2 of the structures 4 between the two adjacent tracks. Moreover, the height or the depth of the structure 4 in a $\pm\theta$ direction with respect to the track T may be preferably smaller than the height or the depth of the structure 4 in other direction. It is to be noted that $\theta = 45°-\delta$. Here, $\delta$ may preferably satisfy $0° < \delta \leq 11°$, and may more preferably satisfy $3° \leq \delta \leq 6°$. More specifically, the height or the depth of the structure 4 in the direction of $\pm45°$ or in the direction of about $\pm45°$ with respect to the track may be preferably smaller than the height or the depth of the structure 4 in the extending direction of the track.

The inclination angle of the structure 4 may be preferably different depending on the in-plane direction of the surface of the base 3. More specifically, the inclination angle $\theta2$ of the structure 4 in a direction of $\pm\theta$ with respect to the track T may be preferably more moderate than the inclination angle $\theta1$ of the structure 4 in the extending direction of the track.

According to the second embodiment, an effect similar to the effect in the first embodiment is achieved.

<3. Third Embodiment>

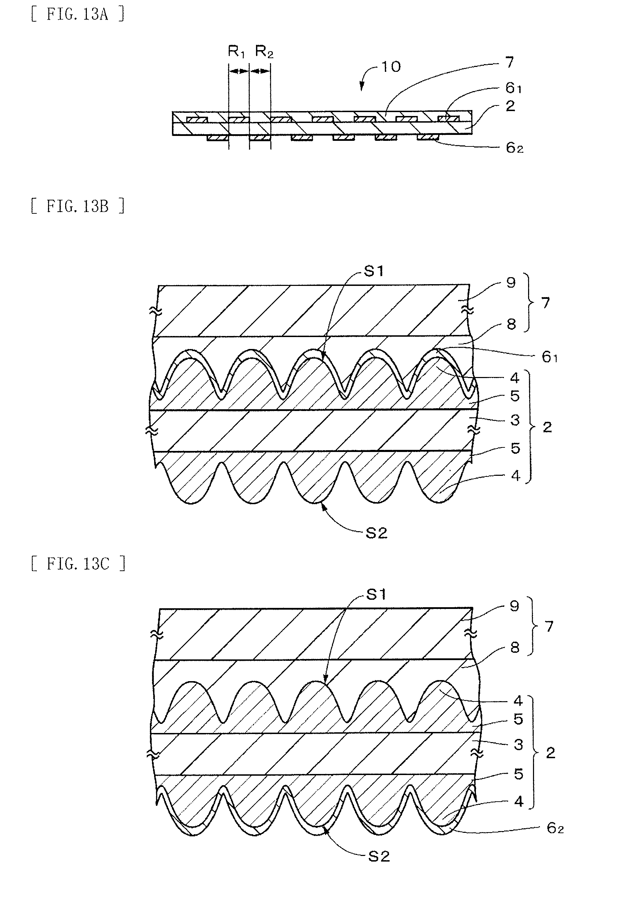

FIG. 13A is a cross-sectional view illustrating an example of a configuration of a conductive optical device according to a third embodiment of the technology. FIG. 13B is an enlarged cross-sectional view illustrating the first region $R_1$ illustrated in FIG. 13A in an enlarged manner. FIG. 13C is an enlarged cross-sectional view illustrating the second region $R_2$ illustrated in FIG. 13A in an enlarged manner. The conductive optical device 10 according to the third embodiment includes the optical layer (first optical layer) 2, a transparent conductive layer $6_1$, and a transparent conductive layer $6_2$. The optical layer (first optical layer) 2 has corrugated surfaces S1 and S2 on both principal surfaces thereof. The transparent conductive layer $6_1$ is so formed on the corrugated surface S1 as to follow along the corrugated surface S1. The transparent conductive layer $6_2$ is so formed on the corrugated surface S2 as to follow along the corrugated surface S2.

The corrugated surface S1 of the optical layer 2 is provided alternately with the first region $R_1$ formed with the transparent conductive layer $6_1$ and the second region $R_2$ formed with no transparent conductive layer 6, and the transparent conductive layer $6_1$ thus has a predetermined pattern. The corrugated surface S2 of the optical layer 2 is provided alternately with the second region $R_2$ formed with the transparent conductive layer $6_2$ and the first region $R_1$ formed with no transparent conductive layer 6, and the transparent conductive layer $6_2$ thus has a predetermined pattern.

The transparent conductive layer $6_1$ having a predetermined pattern and the transparent conductive layer $6_2$ having a predetermined pattern may be, for example, in a relationship in which extending directions of the transparent conductive layers $6_1$ and $6_2$ are orthogonal to each other.

Moreover, as illustrated in FIGs. 13A to 13C, a configuration that further includes the optical layer (second optical layer) 7 formed on the transparent conductive layer $6_1$ may be employed on an as-necessary basis. The conductive optical device 10 may preferably have flexibility.

<4. Fourth Embodiment>

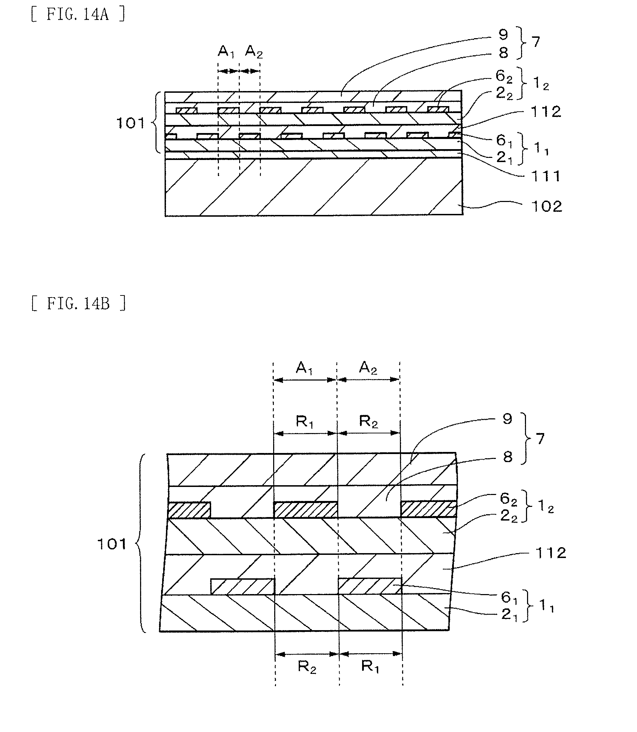

FIG. 14A is a cross-sectional view for describing an example of a configuration of an information input unit (input device) according to a fourth embodiment of the technology. As illustrated in FIG. 14A, the information input unit 101 is provided on a display surface of a display unit 102. The information input unit 101 may be attached to the display surface of the display unit 102 with the use of an attaching layer 111, for example. The display unit 102 to which the information input unit 101 is applied is not particularly limited; however, examples of the display unit 102 may include various display units such as a liquid crystal display, a CRT (Cathode Ray Tube) display, a plasma display (Plasma Display Panel: PDP), an electroluminescence (EL) display, and a surface-conduction electron-emitter display (SED).

The information input unit 101 is a so-called projection-type capacitance-scheme touch panel, and includes a first conductive optical device $1_1$, a second conductive optical device $1_2$ provided on the first conductive optical device $1_1$, and the optical layer 7 provided on the second conductive optical device $1_2$. The first conductive optical device $1_1$ is attached to the second conductive optical device $1_2$ with an attaching layer 112 in between so that a surface, of the first conductive optical device $1_1$, on the transparent conductive layer $6_1$ side is opposed to a surface, of the second conductive optical device $1_2$, on the base 3 side. The optical layer 7 is formed by attaching the base 9 to a surface, of the second conductive optical device $1_2$, on the transparent conductive layer $6_2$ side with the attaching layer 8 in between.

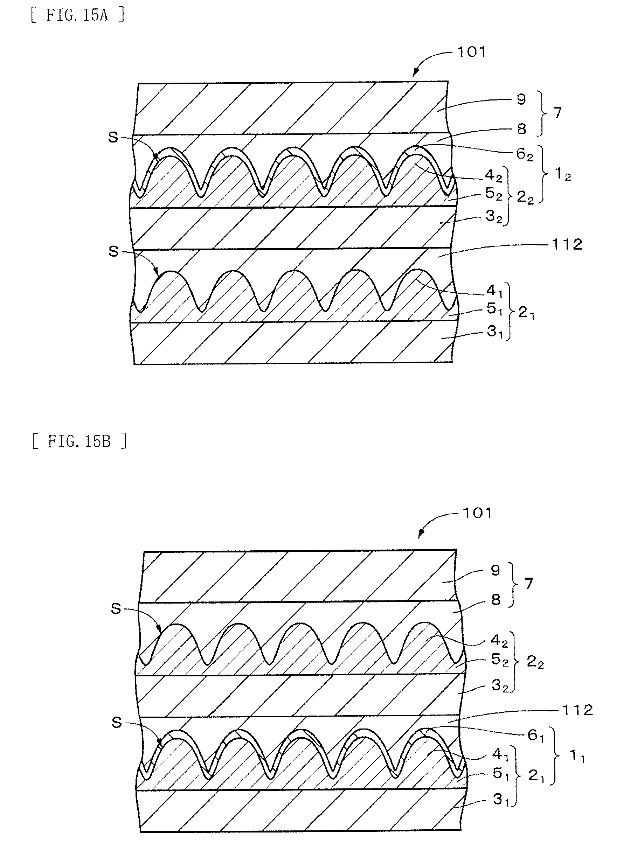

FIG. 14B is an enlarged cross-sectional view illustrating a region $A_1$ and a region $A_2$ illustrated in FIG. 14A in an enlarged manner. FIG. 15A is an enlarged cross-sectional view illustrating the region $A_1$ illustrated in FIG. 14A in a further enlarged manner. FIG. 15B is an enlarged cross-sectional view illustrating the region $A_2$ illustrated in FIG. 14A in a further enlarged manner.

As illustrated in FIG. 14B, the transparent conductive layer $6_1$ of the first conductive optical device $1_1$ and the transparent conductive layer $6_2$ of the second conductive optical device $1_2$ may be preferably provided so as not to overlap each other in a thickness direction of the information input unit 101. Specifically, the first region $R_1$ of the first conductive optical device $1_1$ and the second region $R_2$ of the second conductive optical device $1_2$ may preferably overlap each other in the thickness direction of the information input unit 101, and the second region $R_2$ of the first conductive optical device $1_1$ and the first region $R_1$ of the second conductive optical device $1_2$ may preferably overlap each other in the thickness direction of the information input unit 101. This makes it possible to reduce a difference in transmittance resulting from overlapping of the first conductive optical device $1_1$ and the second conductive optical device $1_2$. It is to be noted that FIGs. 14A and 14B illustrate, as an example, a case in which a direction of the first conductive optical device $1_1$ and a direction of the second conductive optical device $1_2$ are so set that both of the transparent conductive layer $6_1$ of the first conductive optical device $1_1$ and the transparent conductive layer $6_2$ of the second conductive optical device $1_2$ are provided on the input surface side. However, the directions of the first conductive optical device $1_1$ and the second conductive optical device $1_2$ are not particularly limited, and may be appropriately set depending on a design of the information input unit 101.

As illustrated in FIG. 15A, in the region $A_1$, the corrugated surface S of the first conductive optical device $1_1$ may be preferably formed with no transparent conductive layer $6_1$, and the corrugated surface S of the second conductive optical device $1_2$ may be preferably formed with the transparent conductive layer $6_2$. Also, as illustrated in FIG. 15B, in the region $A_2$, the corrugated surface S of the first conductive optical device $1_1$ may be preferably formed with the transparent conductive layer $6_1$, and the corrugated surface S of the second conductive optical device $1_2$ may be preferably formed with no transparent conductive layer $6_2$.

As each of the first conductive optical device $1_1$ and the second conductive optical device $1_2$, one of the conductive optical devices 1 of the first and second embodiments may be used. Specifically, an optical layer $2_1$, a base $3_1$, structures $4_1$, a basal layer $5_1$, and the transparent conductive layer $6_1$ of the first conductive optical device $1_1$ are similar to the optical layer 2, the base 3, the structures 4, the basal layer 5, and the transparent conductive layer 6 of one of the first and second embodiments, respectively. Also, an optical layer $2_2$, a base $3_2$, structures $4_2$, a basal layer $5_2$, and the transparent conductive layer $6_2$ of the second conductive optical device $1_2$ are similar to the optical layer 2, the base 3, the structures 4, the basal layer 5, and the transparent conductive layer 6 of one of the first and second embodiments, respectively.

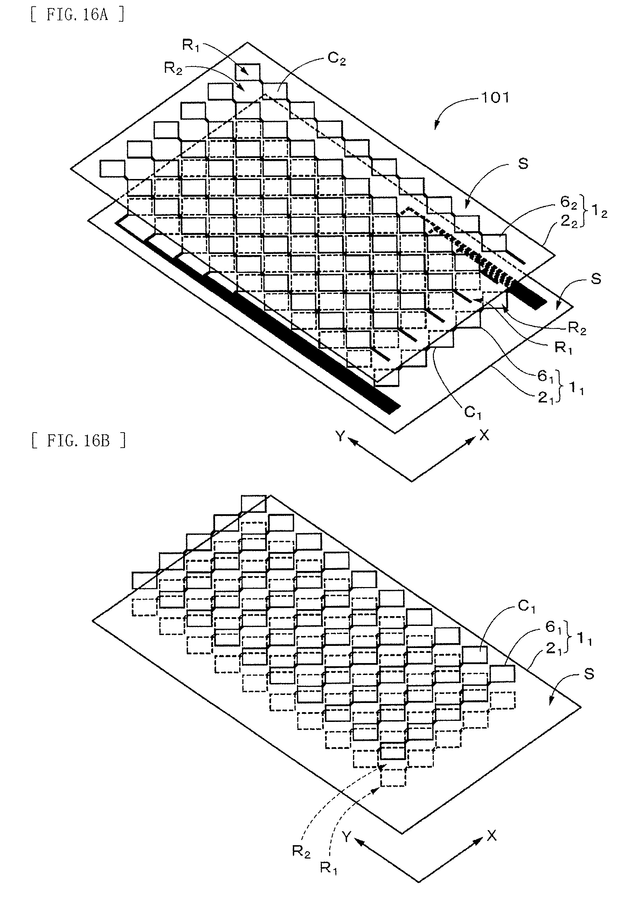

FIG. 16A is an exploded perspective view for describing an example of the configuration of the information input unit according to the fourth embodiment of the technology. The information input unit 101 is a projection-type capacitance-scheme touch panel of an ITO Grid scheme. The transparent conductive layer $6_1$ of the first conductive

optical device $1_1$ may be, for example, an X electrode (first electrode) having a predetermined pattern. The transparent conductive layer $6_2$ of the second conductive optical device $1_2$ may be, for example, a Y electrode (second electrode) having a predetermined pattern. The X electrode and the Y electrode may be, for example, in a relationship in which the X electrode and the Y electrode are orthogonal to each other.

FIG. 16B is an exploded perspective view for describing an example of the configuration of the first conductive optical device provided in the information input unit according to the fourth embodiment of the technology. It is to be noted that illustration of an exploded perspective view of the second conductive optical device $1_2$ is omitted because the second conductive optical device $1_2$ is similar to the first conductive optical device $1_1$ except for a formation direction of the Y electrode that is configured of the transparent conductive layer $6_2$.

In the region $R_1$ in the corrugated surface S of the optical layer $2_1$, a plurality of X electrodes each configured of the transparent conductive layer $6_1$ are arrayed. In the region $R_2$ in the corrugated surface S of the optical layer $2_2$, a plurality of Y electrodes each configured of the transparent conductive layer $6_2$ are arrayed. Each of the X electrodes that extend in the X-axis direction is configured of unit shape elements $C_1$ that are repeatedly linked in the X-axis direction. Each of the Y electrodes that extend in the Y-axis direction is configured of unit shape elements $C_2$ that are repeatedly linked in the Y-axis direction. Examples of a shape of each of the unit shape element $C_1$ and the unit shape element $C_2$ may include a rhombus shape (diamond shape), a triangle shape, and a quadrangle shape. However, the shape thereof is not limited to these shapes.

In a state where the first conductive optical device $1_1$ and the second conductive optical device $1_2$ overlap each other, the first region $R_1$ of the first conductive optical device $1_1$ and the second region $R_2$ of the second conductive optical device $1_2$ overlap each other, and the second region $R_2$ of the first conductive optical device $1_1$ and the first region $R_1$ of the second conductive optical device $1_2$ overlap each other. Accordingly, when the information input unit 101 is viewed from the input surface side, the unit shape elements $C_1$ do not overlap the unit shape elements $C_2$, and the unit shape elements $C_1$ and the unit shape elements $C_2$ are seen to be in a state in which the unit shape elements $C_1$ and the unit shape elements $C_2$ are tiled on a principal surface and are closely packed therein.

<5. Fifth Embodiment>

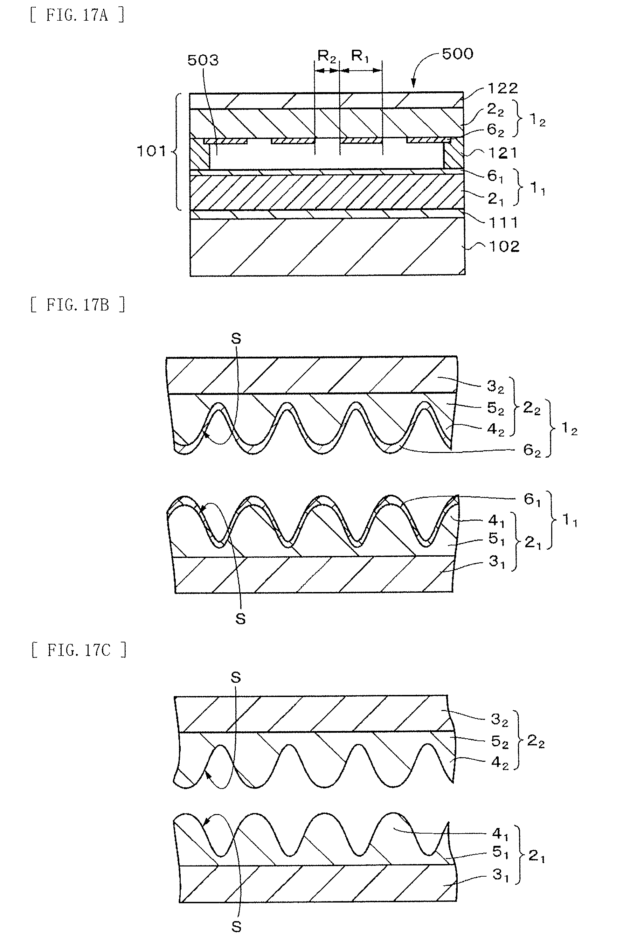

FIG. 17A is a cross-sectional view for describing an example of the configuration of the information input unit according to a fifth embodiment of the technology. FIG. 17B is a cross-sectional view illustrating, in an enlarged manner, a region in which corrugated surfaces formed with respective transparent conductive layers are opposed to each other. FIG. 17C is a cross-sectional view illustrating, in an enlarged manner, a region in which the corrugated surfaces, formed with no transparent conductive layers and thus exposed, are opposed to each other.

As illustrated in FIG. 17A, the information input unit 101 is a so-called matrix opposed-film-scheme touch panel, and includes the first conductive optical device $1_1$, the second conductive optical device $1_2$, and an attaching layer 121. The first conductive optical device $1_1$ and the second conductive optical device $1_2$ are arranged to be opposed to each other separated by a predetermined distance so that the transparent conductive layer $6_1$ and the transparent conductive layer $6_2$ thereof are opposed to each other. The attaching layer 121 is arranged between peripheral portions of the first conductive optical device $1_1$ and the second conductive optical device $1_2$. The peripheral portions of the opposed surfaces of the first conductive optical device $1_1$ and the second conductive optical device $1_2$ are attached to each other with the attaching layer 121 in between. Usable examples of the attaching layer 121 may include adhesive paste and an adhesive tape.

A principal surface on the second conductive optical device $1_2$ side out of both principal surfaces of the information input unit 101 serves as a touch surface (information input surface) to which information is inputted. Further, a hard coat layer 122 may be preferably provided on the touch surface, because it is thereby possible to improve abrasion resistance of the touch surface of a touch panel 50.

As illustrated in FIGs. 17B and 17C, the corrugated surface S of the first conductive optical device $1_1$ and the corrugated surface S of the second conductive optical device $1_2$ are arranged to be opposed to each other and are separated by a predetermined distance. In the information input unit 101 that is a matrix opposed-film-scheme touch panel, the corrugated surface S of the first conductive optical device $1_1$ and the corrugated surface S of the second conductive optical device $1_2$ are formed with the transparent conductive layer $6_1$ and the transparent conductive layer $6_2$ each having a predetermined pattern, respectively. Accordingly, a region in which the corrugated surface S formed with the transparent conductive layer $6_1$ is opposed to the corrugated surface S formed with the transparent conductive layer $6_2$ (FIG. 17B), a region in which the corrugated surface S formed with no transparent conductive layer $6_1$ and thus exposed is opposed to the corrugated surface S formed with no transparent conductive layer $6_2$ and thus exposed (FIG. 17C), and a region in which the corrugated surface S formed with the transparent conductive layer $6_1$ or the transparent conductive layer $6_2$ is opposed to the corrugated surface S formed with no transparent conductive layer $6_1$ or no transparent conductive layer $6_2$ and thus exposed (illustration thereof is omitted) are present in the information input unit 101.

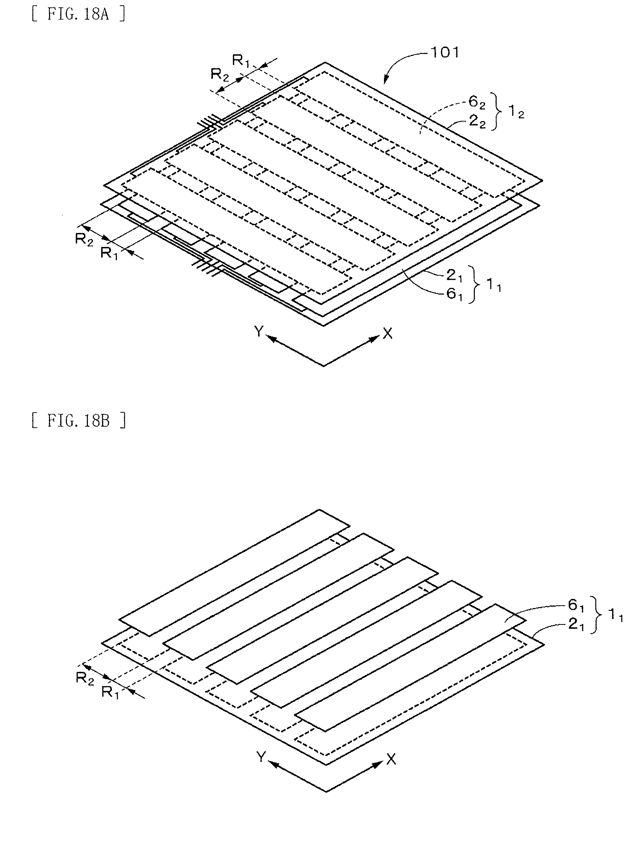

FIG. 18A is an exploded perspective view for describing an example of the configuration of the information input unit according to the fifth embodiment of the technology. FIG. 18B is an exploded perspective view for describing an example of the configuration of the conductive optical device provided in the information input unit according to the fifth embodiment of the technology. The transparent conductive layer $6_1$ of the first conductive optical device $1_1$ may be, for example, an X electrode (first electrode) having a strip shape. The transparent conductive layer $6_2$ of the second conductive optical device $1_2$ may be, for example, a Y electrode (second electrode) having a strip shape. The first conductive optical device $1_1$ and the second conductive optical device $1_2$ are arranged to be opposed to each other so that the X electrode and the Y electrode are opposed to each other and are orthogonal to each other.

The fifth embodiment is similar to the fourth embodiment except for what is described above.

<6. Sixth Embodiment>

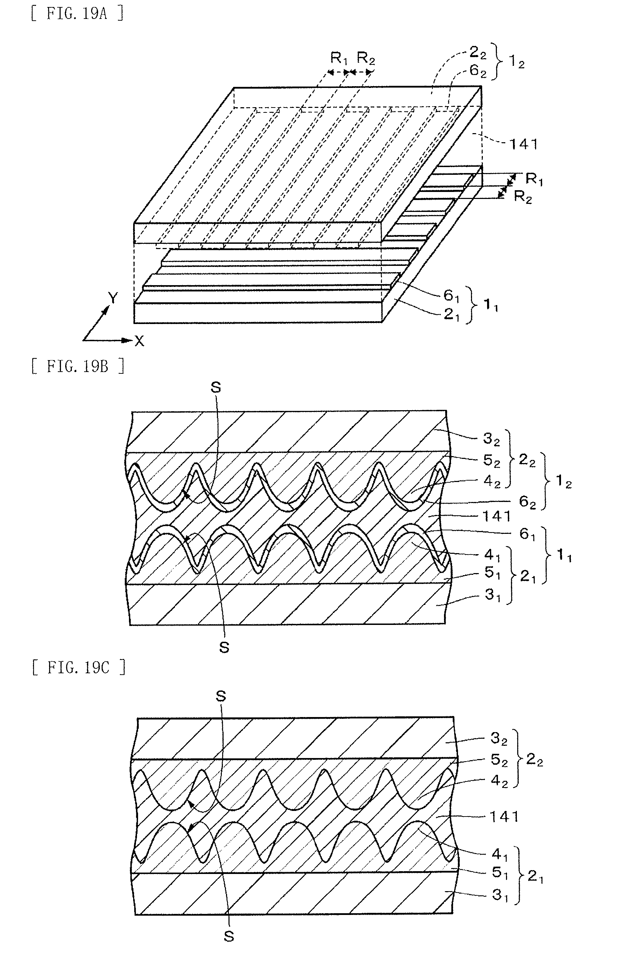

FIG. 19A is a perspective view for describing an example of a configuration of an information display unit (display device) according to a sixth embodiment of the technology. FIG. 19B is a cross-sectional view illustrating, in an enlarged manner, a region in which the corrugated surfaces formed with the respective transparent conductive layers are opposed to each other. FIG. 19C is a cross-sectional view illustrating, in an enlarged manner, a region in which the corrugated surfaces, formed with no transparent conductive layer and thus exposed, are opposed to each other.

As illustrated in FIG. 19A, the information display unit is a liquid crystal display unit of a passive matrix drive scheme (also called a simple matrix drive scheme), and includes the first conductive optical device $1_1$, the second conductive optical device $1_2$, and a liquid crystal layer 141. The first conductive optical device $1_1$ and the second conductive optical device $1_2$ are arranged to be opposed to each other and are separated by a predetermined distance so that the transparent conductive layer $6_1$ and the transparent conductive layer $6_2$ thereof are opposed to each other. The liquid crystal layer 141 is provided between the first conductive optical device $1_1$ and the second conductive optical device $1_2$ that are arranged to be separated by a predetermined distance. As each of the first conductive optical device $1_1$ and the second conductive optical device $1_2$, one of the conductive optical devices 1 of the first and second embodiments may be used. Specifically, the optical layer $2_1$, the base $3_1$, the structures $4_1$, the basal layer $5_1$, and the transparent conductive layer $6_1$ of the first conductive optical device $1_1$ are similar to the optical layer 2, the base 3, the structures 4, the basal layer 5, and the transparent conductive layer 6 of one of the first and second embodiments, respectively. Also, the optical layer $2_2$, the base $3_2$, the structures $4_2$, the basal layer $5_2$, and the transparent conductive layer $6_2$ of the second conductive optical device $1_2$ are similar to the optical layer 2, the base 3, the structures 4, the basal layer 5, and the transparent conductive layer 6 of one of the first and second embodiments, respectively. Here, description is provided of an example in which the technology is applied to the liquid crystal display unit of a passive matrix drive scheme. However, the information display unit is not limited to this example, and the technology is applicable to any information display unit that has a predetermined electrode pattern of a passive matrix drive scheme or the like. For example, the technology is applicable to an EL display unit of a passive matrix drive scheme.

As illustrated in FIGs. 19B and 19C, the corrugated surfaces S of the first conductive optical device $1_1$ and the second conductive optical device $1_2$ are arranged to be opposed to each other and are separated by a predetermined distance. In the liquid crystal display unit of a passive matrix drive scheme, the corrugated surfaces S of the first conductive optical device $1_1$ and the second conductive optical device $1_2$ are formed with the transparent conductive layer $6_1$ and the transparent conductive layer $6_2$ each having a predetermined pattern, respectively. Accordingly, a region in which the corrugated surface S formed with the transparent conductive layer $6_1$ is opposed to the corrugated surface S formed with the transparent conductive layer $6_2$ (FIG. 19B), a region in which the corrugated surface S formed with no transparent conductive layer $6_1$ and thus exposed is opposed to the corrugated surface S formed with no transparent conductive layer $6_2$ and thus exposed (FIG. 19C), and a region in which the corrugated surface S formed with the transparent conductive layer $6_1$ or the transparent conductive layer $6_2$ is opposed to the corrugated surface S formed with no transparent conductive layer $6_1$ or no transparent conductive layer $6_2$ and thus exposed (illustration thereof is omitted) are present.

The transparent conductive layer $6_1$ of the first conductive optical device $1_1$ may be, for example, an X electrode (first electrode) having a strip shape. The transparent conductive layer $6_2$ of the second conductive optical device $1_2$ may be, for example, a Y electrode (second electrode) having a strip shape. The first conductive optical device $1_1$ and the second conductive optical device $1_2$ are arranged to be opposed to each other so that the X electrode and the Y electrode are opposed to each other and are orthogonal to each other.

<7. Seventh Embodiment>

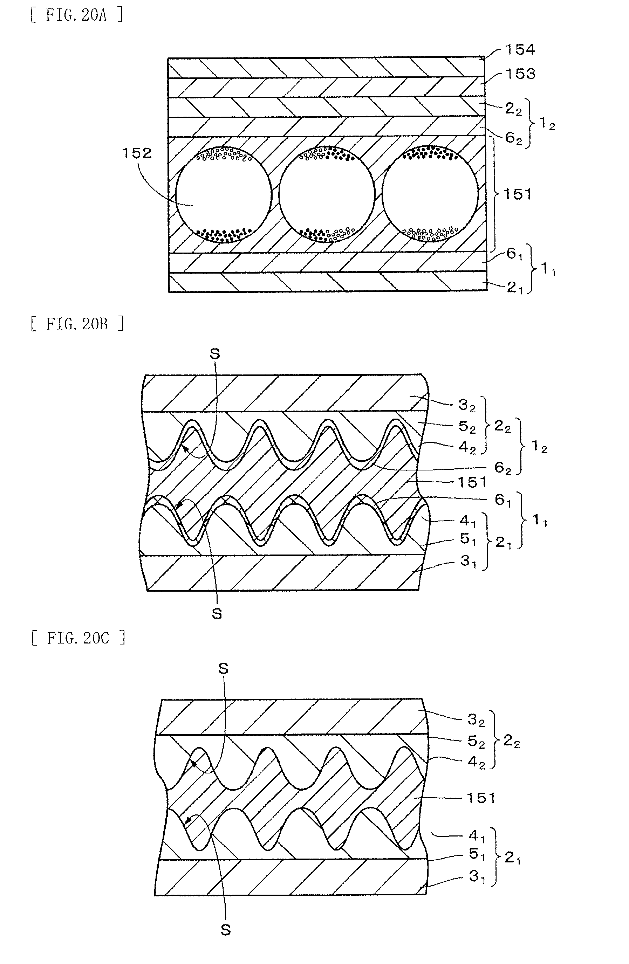

FIG. 20A is a cross-sectional view for describing an example of the configuration of the information display unit according to a seventh embodiment of the technology. FIG. 20B is a cross-sectional view illustrating, in an enlarged manner, a region in which the corrugated surfaces formed with the respective transparent conductive layers are opposed to each other. FIG. 20C is a cross-sectional view illustrating, in an enlarged manner, a region in which the corrugated surfaces, formed with no transparent conductive layer and thus exposed, are opposed to each other.

As illustrated in FIG. 20A, the information display unit is a so-called electronic paper of a microcapsule electrophoresis scheme, and includes the first conductive optical device $1_1$, the second conductive optical device $1_2$, and a microcapsule layer (medium layer) 151. The first conductive optical device $1_1$ and the second conductive optical device $1_2$ are arranged to be opposed to each other and are separated by a predetermined distance so that the transparent conductive layer $6_1$ and the transparent conductive layer $6_2$ thereof are opposed to each other. The microcapsule layer 151 is provided between the first conductive optical device $1_1$ and the second conductive optical device $1_2$ that are arranged to be separated by a predetermined distance.

Moreover, the second conductive optical device $1_2$ may be attached to a supporting member 154 with an attaching layer 153 in between. Examples of the attaching layer 153 may include an adhesive agent, and examples of the supporting member 154 may include glass. Here, description is provided of an example in which the technology is applied to an electronic paper of a microcapsule electrophoresis scheme. However, the electronic paper is not limited to this example, and the technology is applicable to any configuration in which a medium layer is provided between conductive devices that are arranged to be opposed to each other. Here, the medium also encompasses gas such as air other than liquid and solid. Also, the medium may encompass a member such as a capsule, a pigment, and a particle.

Examples of an electronic paper to which the technology is applicable other than that of a microcapsule electrophoresis scheme may include electronic papers of a twist ball scheme, a thermal rewritable scheme, a toner display scheme, an in-plane-type electrophoresis scheme, and an electronic grain scheme. The microcapsule layer 151 includes a number of microcapsules 152. For example, transparent liquid (dispersion medium) in which black particles and white particles are dispersed may be enclosed in each of the microcapsules.

The transparent conductive layer $6_1$ of the first conductive optical device $1_1$ and the transparent conductive layer $6_2$ of the second conductive optical device 12 are each formed to have a predetermined electrode pattern depending on a drive scheme of the information display unit that is the electronic paper. Examples of the drive scheme may include a simple matrix drive scheme, an active matrix drive scheme, and a segmented drive scheme.

As illustrated in FIGs. 20B and 20C, the corrugated surfaces S of the first conductive optical device $1_1$ and the second conductive optical device $1_2$ are arranged to be opposed to each other and are separated by a predetermined distance. In the electronic paper of a passive matrix drive scheme, the corrugated surfaces S of the first conductive optical device $1_1$ and the second conductive optical device $1_2$ are formed with the transparent conductive layer $6_1$ and the transparent conductive layer $6_2$ each having a predetermined pattern, respectively. Accordingly, a region in which the corrugated surface S formed with the transparent conductive layer $6_1$ is opposed to the corrugated surface S formed with the transparent conductive layer $6_2$ (FIG. 20B), a region in which the corrugated surface S formed with no transparent conductive layer $6_1$ and thus exposed is opposed to the corrugated surface S formed with no transparent conductive layer $6_2$ and thus exposed (FIG. 20C), and a region in which the corrugated surface S formed with the transparent conductive layer $6_1$ or the transparent conductive layer $6_2$ is opposed to the corrugated surface S formed with no transparent conductive layer $6_1$ or no transparent conductive layer $6_2$ and thus exposed (illustration thereof is omitted) are present.

The seventh embodiment is similar to the sixth embodiment except for what is described above.

EXAMPLES

The technology is specifically described below referring to Examples; however, the technology is not limited only to the Examples.

(Height H, Arrangement Pitch P, and Aspect Ratio (H/P))

The height H, the arrangement pitch P, and the aspect ratio (H/P) of the structures of the conductive optical sheet or the like were determined below as follows.

First, the conductive optical sheet was so cut as to include the apex portions of the structures, and the cross section thereof was shot by TEM. Next, the arrangement pitch P of the structures and the height H of the structures were determined based on the shot TEM photograph. It is to be noted that, in a case where the height H of the structures had anisotropy in the in-plane direction, the height H of the structures was determined to be the highest height of the structures. To give an example, in a case where the structures were arrayed in a quasi-hexagonal lattice pattern, the height H of the structures was determined to be the height of the structures in the line direction. Next, the aspect ratio (H/P) was determined with the use of the arrangement pitch P and the height H.

(Thicknesses of $SiO_2$ Layer and ITO Layer)

The thicknesses of the $SiO_2$ layer and the ITO layer were determined below as follows.

First, the conductive optical sheet was so cut as to include the apex portions of the structures, and the cross section thereof was shot by a transmission electron microscope (TEM). The thicknesses of the $SiO_2$ layer and the ITO layer at the apex portion of the structure were measured based on the shot TEM photograph.

(Example 1)

First, a glass roll-shaped master having an outer diameter of 126 mm was prepared, and a resist layer was deposited on a surface of the glass roll-shaped master as follows. Specifically, photoresist was diluted to 1/10 with thinner, and the diluted resist was applied by a dipping method on a cylindrical surface of the glass roll-shaped master up to a thickness of about 70 nm. Thus, the resist layer was deposited. Next, the glass roll-shaped master as a recording medium was conveyed to the roll-shaped master exposure apparatus illustrated in FIG. 9 and the resist layer was exposed. Thus, latent images that were linked in a spiral shape and configured a quasi-hexagonal lattice pattern across three adjacent tracks were patterned on the resist layer.

Specifically, laser light having power of 0.50 mW/m that performed exposure onto the surface of the glass roll-shaped master was applied onto a region in which an exposure pattern having a quasi-hexagonal lattice pattern to be formed, and an exposure pattern having a quasi-hexagonal lattice pattern was formed thereby. It is to be noted that a thickness of the resist layer in the line direction of the track lines was about 60 nm, and the thickness of the resist in the extending direction of the track was about 50 nm.

Next, a development processing was performed on the resist layer on the glass roll-shaped master, and the resist layer in the exposed portion was dissolved to perform development. Specifically, the undeveloped glass roll-shaped master was placed on a turntable of an unillustrated development machine, and a developer was dropped onto the surface of the glass roll-shaped master while causing the glass roll-shaped master to rotate together with the turntable. Thus, the resist layer on the surface of the glass roll-shaped master was developed. As a result, a resist glass master in which the resist layer is provided with openings having a quasi-hexagonal lattice pattern was obtained.

Next, plasma etching under $CHF_3$ gas atmosphere was performed with the use of a roll etching apparatus. On the surface of the glass roll-shaped master, etching was thereby progressed only in a portion of the quasi-hexagonal pattern that was exposed from the resist layer whereas etching was not performed on other regions because the resist layer served as a mask, and concave portions each having an elliptical cone shape were formed on the glass roll-shaped master. At this time, an etching amount (depth) was adjusted by adjusting etching time. Lastly, the resist layer was completely removed by $O_2$ ashing, and a moth-eye glass roll-shaped master having a concave-shaped quasi-hexagonal lattice pattern was obtained. A depth H2 of the concave portion in the line direction was deeper than a depth H1 of the concave portion in the extending direction of the track.

Next, a plurality of structures were fabricated on a PET sheet having a thickness of 125 $\mu$m by UV imprinting with the use of the moth-eye glass roll-shaped master described above. Specifically, the moth-eye glass roll-shaped master was closely attached to the PET (polyethylene terephthalate) sheet on which a ultraviolet-curable resin was applied, and the PET sheet was peeled off from the moth-eye glass roll-shaped master while applying ultraviolet rays to cure the resin. As a result, an optical sheet below having a principal surface in which the plurality of structures are arrayed was obtained.

Array of structures: Quasi-hexagonal lattice pattern
Shape of structures: Bell shape (almost paraboloid of revolution)
Height H of structures: 110 nm
Aspect ratio y (H/P) of structures: 0.44
Refractive index x (N) of structures: 1.61

Next, an $SiO_2$ layer having a thickness was deposited by a sputtering method in the first region $R_1$ on a surface of the PET sheet formed with the structures; whereas, no $SiO_2$ layer was deposited in the second region $R_2$ so that the structures were exposed therefrom.

Deposition conditions of the $SiO_2$ layer are shown below.

Kind of gas: Mixed gas of Ar gas and $O_2$ gas
Thickness of $SiO_2$ layer: 5 nm

Here, the thickness of the $SiO_2$ layer was a thickness at the apex portion of the structure.

Next, an ITO layer was deposited by a sputtering method in the first region $R_1$ on the surface of the PET sheet formed with the structures; whereas, no ITO layer was deposited in the second region $R_2$ so that the structures were exposed therefrom. Thus, a conductive optical sheet was fabricated.

Deposition conditions of the ITO layer are shown below.

Kind of gas: Mixed gas of Ar gas and $O_2$ gas
Thickness of ITO layer: 30 nm

Here, the thickness of the ITO layer was a thickness at the apex portion of the structure.

(Annealing Process)

Next, the PET sheet formed with the ITO layer was annealed in atmosphere to accelerate polycrystallization of the ITO layer. Next, in order to confirm the accelerated state, the ITO layer was measured by X-ray diffraction (XRD), and a peak of $In_2O_3$ was confirmed.
Next, the conductive optical sheet was adhered on a glass substrate having a refractive index of 1.5 with an adhesive sheet in between so that a surface, of the conductive optical sheet, on the ITO layer side was on a glass substrate surface side.
Thus, the aimed conductive optical sheet was fabricated.

(Comparative Example 1)

A conductive optical sheet was fabricated in a manner that was similar to that of Example 1 except for arraying a plurality of structures below on a principal surface of the PET sheet.

Array of structures: Quasi-hexagonal lattice pattern
Shape of structures: Bell shape (almost paraboloid of revolution)
Height H of structures of structures: 110 nm
Aspect ratio y (H/P) of structures: 0.44
Refractive index x (N) of structures: 1.50

(Reflection Spectrum)

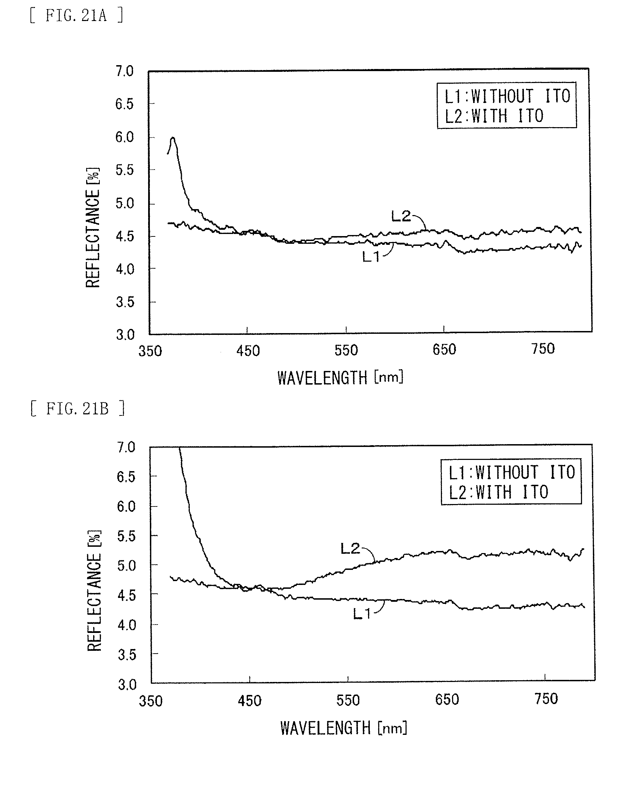

First, a black tape was attached to a surface, of the conductive optical sheet, opposite from a surface thereof to which the glass substrate was attached, and a measurement sample was fabricated thereby. Next, reflection spectrum in each of the first region $R_1$ and the second region $R_2$ in a wavelength range (from about 350 nm to about 800 nm) of a visible periphery of the measurement sample with the use of a spectrophotometer (available from JASCO Corporation, product name: V-550). The results are shown in FIGs. 21A and 21B.

(Non-visibility $\Delta Y$)

First, a black tape was attached to a surface, of the conductive optical sheet having the first region $R_1$ and the second region $R_2$, opposite from a surface thereof to which the glass substrate was attached, and a measurement sample was fabricated thereby. Next, reflectance in each of the first region $R_1$ and the second region $R_2$ at a wavelength of 555 nm of the measurement sample was measured with the use of the spectrophotometer (available from JASCO Corporation, product name: V-550). Subsequently, a difference $\Delta R$ in reflectance was calculated based on the following expression:

$$\Delta R = R_A - R_B$$

where $R_A$ is the reflectance in the first region $R_1$ formed with the ITO layer, and $R_B$ is the reflectance in the second region $R_2$ formed with no ITO layer.
Next, non-visibility $\Delta Y$ was determined based on the following expression. The results are shown in Table 1.

$$\Delta Y \, [\%] = \Delta R \times V$$

where V is spectral luminous efficacy.
Table 1 shows the configuration and non-visibility of the conductive optical sheet in each of Example 1 and Comparative example 1.

[Table 1]

|  | Non-visibility ΔY [%] | Refractive index x | Aspect ratio y | Height H [nm] |
|---|---|---|---|---|
| Example 1 | 0.10 | 1.61 | 0.44 | 110 |
| Comparative example 1 | 0.51 | 1.50 | 0.44 | 110 |

The followings can be seen from Table 1 and FIGs. 21A and 21B.

In Example 1 in which a refractive index N of the structures was 1.61, non-visibility ΔY was 0.1; whereas, in Comparative example 1 in which the refractive index N of the structures was 1.5, the non-visibility ΔY was 0.51. Consequently, by increasing the refractive index N of the structures, it is possible to improve non-visibility ΔY even when the height of the structures is low. In other words, it is possible to reduce the thickness of the transparent conductive layer, and to reduce the cost of the conductive optical sheet.

(Example 2)

A conductive optical sheet was fabricated in a manner that was similar to that of Example 1 except for arraying a plurality of structures below on a principal surface of the PET sheet.

Array of structures: Quasi-hexagonal lattice pattern
Shape of structures: Bell shape (almost paraboloid of revolution)
Height H of structures: 124 nm
Aspect ratio y (H/P) of structures: 0.608
Refractive index x (N) of structures: 1.5

(Example 3)

A conductive optical sheet was fabricated in a manner that was similar to that of Example 2 except for arraying a plurality of structures below on a principal surface of the PET sheet.

Array of structures: Quasi-hexagonal lattice pattern
Shape of structures: Bell shape (almost paraboloid of revolution)
Height H of structures: 111 nm
Aspect ratio y (H/P) of structures: 0.544
Refractive index x (N) of structures: 1.55

(Example 4)

A conductive optical sheet was fabricated in a manner that was similar to that of Example 2 except for arraying a plurality of structures below on a principal surface of the PET sheet.

Array of structures: Quasi-hexagonal lattice pattern
Shape of structures: Bell shape (almost paraboloid of revolution)
Height H of structures of structures: 93 nm
Aspect ratio y (H/P): 0.456
Refractive index x (N) of structures: 1.61

(Example 5)

A conductive optical sheet was fabricated in a manner that was similar to that of Example 2 except for arraying a plurality of structures below on a principal surface of the PET sheet.

Array of structures: Quasi-hexagonal lattice pattern
Shape of structures: Bell shape (almost paraboloid of revolution)
Height H of structures of structures: 78 nm
Aspect ratio y (H/P): 0.382

Refractive index x (N) of structures: 1.67

(Example 6)

A conductive optical sheet was fabricated in a manner that was similar to that of Example 2 except for arraying a plurality of structures below on a principal surface of the PET sheet.

Array of structures: Quasi-hexagonal lattice pattern
Shape of structures: Bell shape (almost paraboloid of revolution)
Height H of structures of structures: 66 nm
Aspect ratio y (H/P): 0.324
Refractive index x (N) of structures: 1.71

(Example 7)

A conductive optical sheet was fabricated in a manner that was similar to that of Example 2 except for arraying a plurality of structures below on a principal surface of the PET sheet.

Array of structures: Quasi-hexagonal lattice pattern
Shape of structures: Bell shape (almost paraboloid of revolution)
Height H of structures of structures: 114 nm
Aspect ratio y (H/P): 0.559
Refractive index x (N) of structures: 1.5

(Example 8)

A conductive optical sheet was fabricated in a manner that was similar to that of Example 2 except for arraying a plurality of structures below on a principal surface of the PET sheet.

Array of structures: Quasi-hexagonal lattice pattern
Shape of structures: Bell shape (almost paraboloid of revolution)
Height H of structures of structures: 97 nm
Aspect ratio y (H/P): 0.475
Refractive index x (N) of structures: 1.55

(Example 9)

A conductive optical sheet was fabricated in a manner that was similar to that of Example 2 except for arraying a plurality of structures below on a principal surface of the PET sheet.

Array of structures: Quasi-hexagonal lattice pattern
Shape of structures: Bell shape (almost paraboloid of revolution)
Height H of structures of structures: 74 nm
Aspect ratio y (H/P): 0.363
Refractive index x (N) of structures: 1.61

(Example 10)

A conductive optical sheet was fabricated in a manner that was similar to that of Example 2 except for arraying a plurality of structures below on a principal surface of the PET sheet.

Array of structures: Quasi-hexagonal lattice pattern
Shape of structures: Bell shape (almost paraboloid of revolution)
Height H of structures of structures: 140 nm
Aspect ratio y (H/P): 0.686
Refractive index x (N) of structures: 1.5

(Example 11)

A conductive optical sheet was fabricated in a manner that was similar to that of Example 2 except for arraying a plurality of structures below on a principal surface of the PET sheet.

    Array of structures: Quasi-hexagonal lattice pattern
    Shape of structures: Bell shape (almost paraboloid of revolution)
    Height H of structures of structures: 140 nm
    Aspect ratio y (H/P): 0.686
    Refractive index x (N) of structures: 1.71

(Comparative Example 2)

A conductive optical sheet was fabricated in a manner that was similar to that of Example 2 except for arraying a plurality of structures below on a principal surface of the PET sheet.

    Array of structures: Quasi-hexagonal lattice pattern
    Shape of structures: Bell shape (almost paraboloid of revolution)
    Height H of structures of structures: 110 nm
    Aspect ratio y (H/P): 0.539
    Refractive index x (N) of structures: 1.50

(Non-visibility $\Delta Y$)

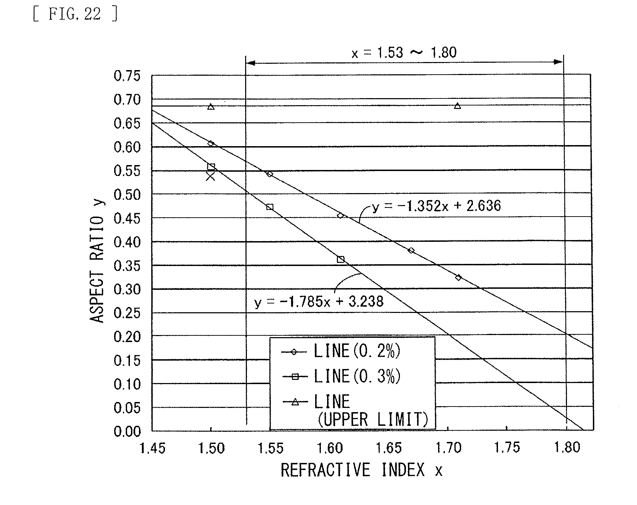

Non-visibility $\Delta Y$ of each of the conductive optical sheets fabricated as described above was determined in a manner similar to that in Example 1 and Comparative example 1 described above. The results are shown in FIG. 22.
Table 2 shows a configuration and non-visibility of the conductive optical sheet in each of Examples 2 to 11 and Comparative example 2.

[Table 2]

| | Non-visibility $\Delta Y$ [%] | Refractive index x | Aspect ratio y | Height H [nm] |
|---|---|---|---|---|
| Example 2 | 0.20 | 1.50 | 0.608 | 124 |
| Example 3 | 0.22 | 1.55 | 0.544 | 111 |
| Example 4 | 0.25 | 1.61 | 0.456 | 93 |
| Example 5 | 0.24 | 1.67 | 0.382 | 78 |
| Example 6 | 0.27 | 1.71 | 0.324 | 66 |
| Example 7 | 0.30 | 1.50 | 0.559 | 114 |
| Example 8 | 0.32 | 1.55 | 0.475 | 97 |
| Example 9 | 0.36 | 1.61 | 0.363 | 74 |
| Example 10 | 0.07 | 1.50 | 0.686 | 140 |
| Example 11 | 0.04 | 1.71 | 0.686 | 140 |
| Comparative example 2 | 0.51 | 1.50 | 0.539 | 110 |

The followings can be seen from FIG. 22.

By causing the refractive index x and the aspect ratio y of the structures to satisfy the following relational expressions (1) and (2), it is possible to set non-visibility $\Delta Y$ to be in a range of 0.3% or lower.

$$y \geq -1.785x + 3.238 \qquad (1)$$

$$y \le 0.686 \qquad (2)$$

By causing the refractive index x and the aspect ratio y of the structures to satisfy the following relational expressions (2) and (3), it is possible to set non-visibility ΔY to be in a range of 0.2% or lower.

$$y \ge -1.352x + 2.636 \qquad (3)$$

$$y \le 0.686 \qquad (2)$$

Some embodiments of the technology have been specifically described above; however, the technology is not limited to the above-described embodiments, and various modifications may be made based on the technical idea of the technology.

For example, the configurations, the methods, the processes, the shapes, the materials, the numerical values, etc. mentioned in the above embodiments are mere examples and a configuration, a method, a process, a shape, a material, a numerical value, etc. different therefrom may be used on an as-necessary basis.

Moreover, the configurations, the methods, the processes, the shapes, the materials, the numerical values, etc. in the above embodiments may be used in combination without deviating from the gist of the technology.

Moreover, the technology may employ the following configurations.

(1) A conductive optical device, including:

a base;
a plurality of structures supported by the base, and arranged at a pitch that is equal to or shorter than a wavelength of visible light; and
a transparent conductive layer provided on a surface-side of the structures, and having a shape that follows along a surface shape of the structures,
wherein the following relational expressions (1) and (2) are satisfied:

$$y \ge -1.785x + 3.238 \qquad (1)$$

$$y \le 0.686 \qquad (2)$$

where x is a refractive index and y is an aspect ratio, of each of the structures.

(2) The conductive optical device according to (1), wherein the following relational expressions (2) and (3) are satisfied:

$$y \ge -1.352x + 2.636 \qquad (3)$$

$$y \le 0.686 \qquad (2)$$

where x is the refractive index and y is the aspect ratio, of each of the structures.
(3) The conductive optical device according to (1) or (2), wherein the refractive index is in a range from 1.53 to 1.8 both inclusive.
(4) The conductive optical device according to (1) or (2), wherein the refractive index is in a range from 1.55 to 1.75 both inclusive.
(5) The conductive optical device according to any one of (1) to (4), wherein a surface of each of the structures includes an inclined surface having an inclination angle that is different depending on an in-plane direction of a surface of the base.
(6) The conductive optical device according to any one of (1) to (5), wherein the transparent conductive layer includes one of an indium tin oxide and a zinc oxide.

(7) The conductive optical device according to any one of (1) to (6), wherein the transparent conductive layer has a mixed state of an amorphous state and a polycrystalline state.

(8) The conductive optical device according to any one of (1) to (7), further including a conductive layer provided between the structures and the transparent conductive layer, the conductive layer including a metal-based material, and having a shape that follows along the surface shape of the structures.

(9) The conductive optical device according to (8), wherein the metal-based material includes one or more metals selected from a group consisting of Ag, Pt, Al, Au, and Cu.

(10) The conductive optical device according to any one of (1) to (9), further including a dielectric layer provided between the structures and the transparent conductive layer, the dielectric layer having a shape that follows along the surface shape of the structures.

(11) The conductive optical device according to any one of (1) to (10), wherein

the structures are arranged to form a plurality of lines of tracks, and form a pattern selected from a group consisting of a hexagonal lattice pattern, a quasi-hexagonal lattice pattern, a tetragonal lattice pattern, and a quasi-tetragonal lattice pattern, and

each of the structures has one of an elliptical cone shape and a truncated elliptical cone shape, the elliptical cone shape and the truncated elliptical cone shape each having a major-axis direction oriented in a direction in which the tracks extend.

(12) The conductive optical device according to any one of (1) to (10), wherein the base includes, on a surface-side thereof, a first region in which the transparent conductive layer is provided, and a second region without the transparent conductive layer.

(13) An input device, including the conductive optical device according to any one of (1) to (12).

(14) A display device, including the conductive optical device according to any one of (1) to (12).

The present application claims the priority on the basis of Japanese Patent Application No. 2012-162093 filed in the Japan Patent Office on July 20, 2012, the entire content of which is hereby incorporated by reference.

It should be understood by those skilled in the art that various modifications, combinations, sub-combinations and alterations may occur depending on design requirements and other factors insofar as they are within the scope of the appended claims or the equivalents thereof.

### Claims

1. A conductive optical device, comprising:

   a base;
   a plurality of structures supported by the base, and arranged at a pitch that is equal to or shorter than a wavelength of visible light; and
   a transparent conductive layer provided on a surface-side of the structures, and having a shape that follows along a surface shape of the structures,
   wherein the following relational expressions (1) and (2) are satisfied:

   $$y \geq -1.785x + 3.238 \qquad (1)$$

   $$y \leq 0.686 \qquad (2)$$

   where x is a refractive index and y is an aspect ratio, of each of the structures.

2. The conductive optical device according to claim 1, wherein the following relational expressions (2) and (3) are satisfied:

   $$y \geq -1.352x + 2.636 \qquad (3)$$

$$y \leq 0.686 \qquad (2)$$

where x is the refractive index and y is the aspect ratio, of each of the structures.

3. The conductive optical device according to claim 1, wherein the refractive index is in a range from 1.53 to 1.8 both inclusive.

4. The conductive optical device according to claim 1, wherein the refractive index is in a range from 1.55 to 1.75 both inclusive.

5. The conductive optical device according to claim 1, wherein a surface of each of the structures includes an inclined surface having an inclination angle that is different depending on an in-plane direction of a surface of the base.

6. The conductive optical device according to claim 1, wherein the transparent conductive layer includes one of an indium tin oxide and a zinc oxide.

7. The conductive optical device according to claim 1, wherein the transparent conductive layer has a mixed state of an amorphous state and a polycrystalline state.

8. The conductive optical device according to claim 1, further comprising a conductive layer provided between the structures and the transparent conductive layer, the conductive layer including a metal-based material, and having a shape that follows along the surface shape of the structures.

9. The conductive optical device according to claim 8, wherein the metal-based material includes one or more metals selected from a group consisting of Ag, Pt, Al, Au, and Cu.

10. The conductive optical device according to claim 1, further comprising a dielectric layer provided between the structures and the transparent conductive layer, the dielectric layer having a shape that follows along the surface shape of the structures.

11. The conductive optical device according to claim 1, wherein
the structures are arranged to form a plurality of lines of tracks, and form a pattern selected from a group consisting of a hexagonal lattice pattern, a quasi-hexagonal lattice pattern, a tetragonal lattice pattern, and a quasi-tetragonal lattice pattern, and
each of the structures has one of an elliptical cone shape and a truncated elliptical cone shape, the elliptical cone shape and the truncated elliptical cone shape each having a major-axis direction oriented in a direction in which the tracks extend.

12. The conductive optical device according to claim 1, wherein the base includes, on a surface-side thereof, a first region in which the transparent conductive layer is provided, and a second region without the transparent conductive layer.

13. An input device, comprising the conductive optical device according to any one of claims 1 to 12.

14. A display device, comprising the conductive optical device according to any one of claims 1 to 12.

[ FIG. 1A ]

[ FIG. 1B ]

[ FIG. 1C ]

[ FIG. 2A ]

[ FIG. 2B ]

[ FIG.3 ]

[ FIG. 4A ]

[ FIG. 4B ]

[ FIG. 5 ]

[ FIG. 6 ]

[ FIG. 7 ]

[ FIG. 8A ]

[ FIG. 8B ]

[ FIG. 8C ]

[ FIG. 9 ]

[ FIG. 10A ]

[ FIG. 10B ]

[ FIG. 10C ]

[ FIG. 10D ]

[ FIG. 11A ]

[ FIG. 11B ]

[ FIG. 11C ]

[ FIG. 11D ]

[ FIG. 12A ]

[ FIG. 12B ]

[ FIG. 13A ]

[ FIG. 13B ]

[ FIG. 13C ]

[ FIG. 14A ]

[ FIG. 14B ]

[ FIG. 15A ]

[ FIG. 15B ]

[ FIG. 16A ]

[ FIG. 16B ]

[ FIG. 17A ]

[ FIG. 17B ]

[ FIG. 17C ]

[ FIG. 18A ]

[ FIG. 18B ]

[ FIG. 19A ]

[ FIG. 19B ]

[ FIG. 19C ]

[ FIG. 20A ]

[ FIG. 20B ]

[ FIG. 20C ]

[ FIG. 21A ]

[ FIG. 21B ]

[ FIG. 22 ]

<table>
<tr><td colspan="3" align="center">**INTERNATIONAL SEARCH REPORT**</td><td colspan="2">International application No.<br>PCT/JP2013/068142</td></tr>
</table>

**A. CLASSIFICATION OF SUBJECT MATTER**
*G02B1/11*(2006.01)i, *B32B7/02*(2006.01)i, *G06F3/041*(2006.01)i, *G09F9/00*
(2006.01)i

According to International Patent Classification (IPC) or to both national classification and IPC

**B. FIELDS SEARCHED**

Minimum documentation searched (classification system followed by classification symbols)
G02B1/11, B32B7/02, G06F3/041, G09F9/00

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2013 |
| Kokai Jitsuyo Shinan Koho | 1971–2013 | Toroku Jitsuyo Shinan Koho | 1994–2013 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2011-230431 A  (Sony Corp.),<br>17 November 2011 (17.11.2011),<br>paragraphs [0015] to [0019], [0024] to [0074],<br>[0111] to [0115], [0139], [0180]<br>& CN 102236462 A      & TW 201214471 A | 1,2,5-14<br>3,4 |
| X<br><br>Y | JP 2011-138059 A  (Sony Corp.),<br>14 July 2011 (14.07.2011),<br>claims; paragraphs [0029], [0030], [0047] to<br>[0049], [0060] to [0062], [0186], [0188],<br>[0201], [0203], [0211]; fig. 31AB, 33AB<br>& US 2011/0310489 A1      & EP 2521011 A1<br>& WO 2011/080890 A1      & CN 102326137 A<br>& TW 201135275 A      & KR 10-2012-0111920 A | 1,2,5-9,11,<br>13,14<br>3,4 |

☒ Further documents are listed in the continuation of Box C.      ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>    04 October, 2013 (04.10.13) | Date of mailing of the international search report<br>    15 October, 2013 (15.10.13) |
|---|---|
| Name and mailing address of the ISA/<br>    Japanese Patent Office | Authorized officer |
| Facsimile No. | Telephone No. |

Form PCT/ISA/210 (second sheet) (July 2009)

**INTERNATIONAL SEARCH REPORT**

| International application No. |
|---|
| PCT/JP2013/068142 |

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2011-53496 A  (Sony Corp.),<br>17 March 2011 (17.03.2011),<br>paragraph [0156]<br>& US 2011/0051249 A1     & CN 102004272 A | 3,4 |
| A | JP 2004-341541 A  (Dainippon Printing Co.,<br>Ltd.),<br>02 December 2004 (02.12.2004),<br>paragraphs [0073], [0077], [0080], [0083]<br>& US 6340404 B1            & EP 667541 A2 | 1,2 |
| A | JP 2012-123086 A  (Sony Corp.),<br>28 June 2012 (28.06.2012),<br>paragraphs [0103], [0105]; fig. 9AB<br>& US 2012/0138342 A1     & CN 102592715 A | 10,12 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003136625 A

- JP 2012162093 A

**Non-patent literature cited in the description**

- Chemistry Handbook. The Chemical Society of Japan, I-537